# EUROPEAN PATENT APPLICATION

(11) **EP 4 636 949 A1**
(43) Date of publication of application: **22.10.2025**
(21) Application number: 24775060.7
(22) Date of filing: 25.01.2024
(51) Int. Cl.: H01Q 1/24, H01Q 1/38, H01R 13/24, H04M 1/02

(54) **ELECTRONIC DEVICE HAVING STRUCTURE FOR COUPLING MODULE INCLUDING ELECTRONIC COMPONENT TO FRAME**

(30) Priority: 21.03.2023 KR 20230036700; 14.04.2023 KR 20230049685
(71) Applicant: Samsung Electronics Co., Ltd., Suwon-si, Gyeonggi-do 16677 (KR)
(72) Inventor: KIM, Kyungpil, Suwon-si Gyeonggi-do 16677 (KR)
(74) Representative: Nederlandsch Octrooibureau
(86) International application number: PCT/KR2024/001242
(87) International publication number: WO 2024/196012

(57) **Abstract**

Provided is an electronic device. The electronic device according to one embodiment comprises: a conductive part including at least one through hole; and an antenna module disposed on the conductive part. The antenna module comprises: a printed circuit board including an antenna radiator; a conductive bracket surrounding at least a portion of the printed circuit board and electrically connected to a ground layer of the printed circuit board; a conductive deformation member accommodated within the conductive bracket and contacting the conductive part and the conductive bracket; and a conductive pin which couples the antenna module to the conductive part by penetrating the at least one through hole, the conductive bracket, and the conductive deformation member.

## Description

### [Technical Field]

The present disclosure relates to an electronic device including a structure for coupling a module including an electronic component to a frame.

### [Background Art]

In order to meet a user's demand, an electronic device may include electronic components capable of providing various functions. The electronic device may include a frame (or a housing) capable of providing a space in which the electronic components are disposed. For example, some of the electronic components may be accommodated in the frame of the electronic device after being manufactured in a form of a module disposed on a printed circuit board.

### [Disclosure]

### [Technical Solution]

An electronic device is provided. According to an embodiment, the electronic device may comprise a conductive portion including at least one through-hole. According to an embodiment, the electronic device may comprise an antenna module disposed on the conductive portion. According to an embodiment, the antenna module may include a printed circuit board including an antenna radiator. According to an embodiment, the antenna module may include a conductive bracket, surrounding at least a portion of the printed circuit board, electrically connected to a ground layer of the printed circuit board. According to an embodiment, the antenna module may include a conductive deformable member, accommodated in the conductive bracket, electrically connecting the conductive bracket to the conductive portion by contacting the conductive portion and the conductive bracket. According to an embodiment, the antenna module may include a conductive pin that couples the antenna module to the conductive portion by penetrating the at least one through-hole, the conductive bracket, and the conductive deformation member.

An electronic device is provided. According to an embodiment, the electronic device may comprise a conductive portion including a surface on which a display is disposed, another surface opposite to the surface, and at least one through-hole. According to an embodiment, the electronic device may comprise an antenna module disposed between the surface of the conductive portion and the another portion of the conductive portion. According to an embodiment, the antenna module may include a printed circuit board including a first surface on which an antenna radiator is disposed, a second surface opposite to the first surface, and a ground layer. According to an embodiment, the antenna module may include a conductive bracket, surrounding at least a portion of the printed circuit board, at least partially attached to the second surface, electrically connected to the ground layer. According to an embodiment, the antenna module may include a conductive deformation member, disposed on an end of the conductive bracket, electrically connecting the conductive bracket to the conductive portion by being interposed between the conductive portion and the conductive bracket. According to an embodiment, the antenna module may include a conductive pin that couples the antenna module to the conductive portion by penetrating the at least one through-hole, the conductive bracket, and the conductive deformation member.

### [Description of the Drawings]

FIG. 1 is a block diagram of an electronic device within a network environment according to various embodiments.
FIG. 2 is a diagram indicating an exemplary electronic device according to an embodiment.
FIG. 3 is an exploded perspective view of an exemplary electronic device according to an embodiment.
FIG. 4A is a perspective view of an exemplary frame and an antenna module according to an embodiment.
FIG. 4B is an exploded perspective view of an exemplary frame and an antenna module according to an embodiment.
FIG. 4C illustrates an example in which an exemplary frame and an antenna module are coupled according to an embodiment.
FIG. 4D is a cross-sectional view illustrating an example of an exemplary electronic device cut along line A-A' of FIG. 4A according to an embodiment.
FIG. 5 is a cross-sectional view illustrating an example of an exemplary electronic device cut along line B-B' of FIG. 4A according to an embodiment.
FIG. 6A is a cross-sectional view illustrating an example of cutting an exemplary electronic device according to an embodiment.
FIG. 6B is a cross-sectional view illustrating an example of cutting an exemplary electronic device according to an embodiment.
FIG. 7A is an exploded perspective view of an exemplary antenna module according to an embodiment.
FIG. 7B is a cross-sectional view illustrating an example of cutting an exemplary electronic device according to an embodiment.
FIGS. 8A, 8B, and 8C indicate an example in which an exemplary antenna module according to an embodiment is coupled in an exemplary conductive portion.
FIGS. 9A, 9B, and 9C indicate an example in which an exemplary antenna module according to an embodiment is coupled in an exemplary conductive portion.
FIG. 10A is an exploded perspective view of an exemplary conductive portion according to an embodiment.
FIG. 10B is a cross-sectional view of an exemplary electronic device according to an embodiment.
FIG. 10C is a diagram illustrating an opening of an exemplary conductive portion according to an embodiment.

### [Mode for Invention]

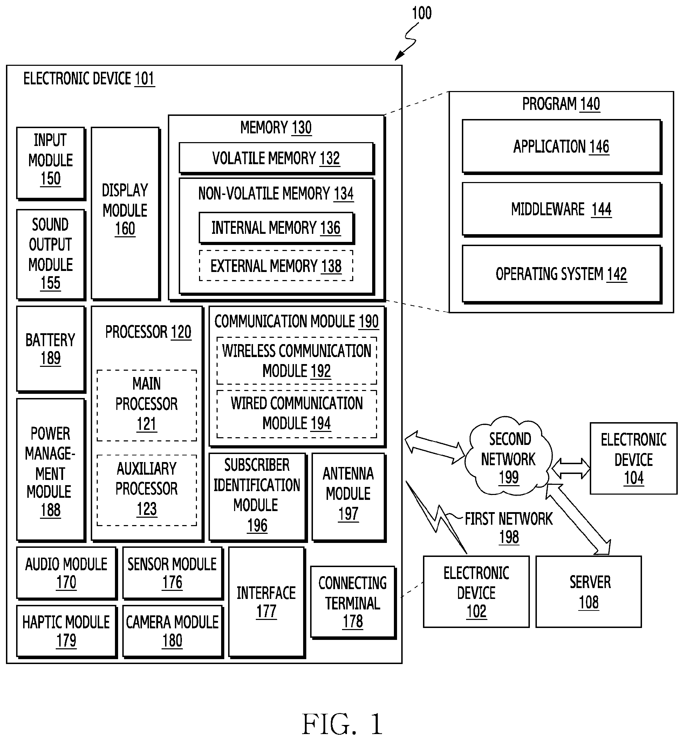

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter wave (mmWave) band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

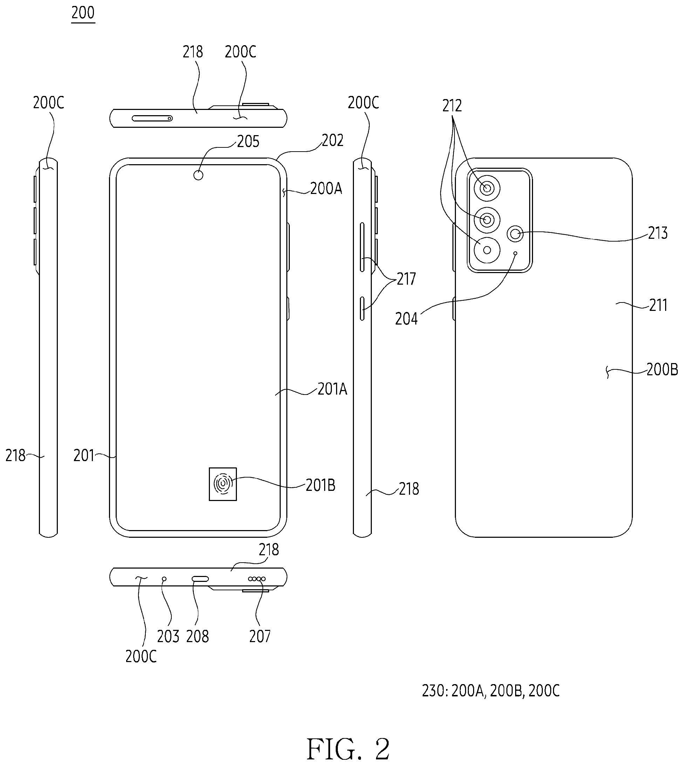

FIG. 2 is a diagram indicating an electronic device according to an embodiment.

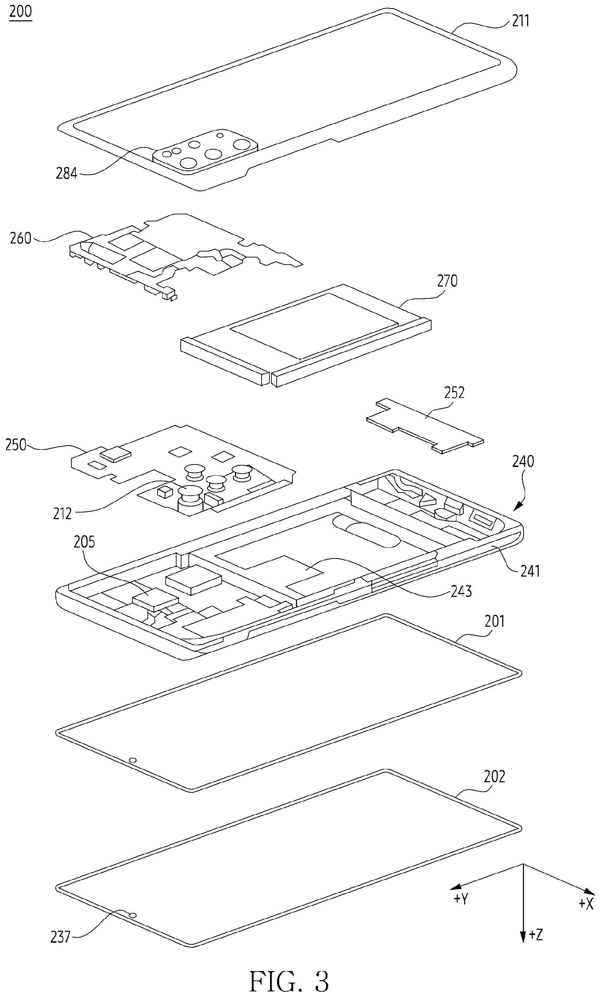

Referring to FIG. 2A, according to an embodiment, an electronic device 200 (e.g., the electronic device 101 of FIG. 1) may include a housing 230 forming an exterior of the electronic device 200. For example, the housing 230 may include a first surface (or a front surface) 200A, a second surface (or a rear surface) 200B, and a third surface (or a lateral surface) 200C surrounding a space between the first surface 200A and the second surface 200B. In an embodiment, the housing 230 may refer to a structure (e.g., a frame 240 of FIG. 3) forming at least a portion of the first surface 200A, the second surface 200B, and/or the third surface 200C.

According to an embodiment, the electronic device 200 may include a substantially transparent front plate 202. In an embodiment, the front plate 202 may form at least a portion of the first surface 200A. In an embodiment, the front plate 202, for example, may include a glass plate or a polymer plate including various coating layers, but is not limited thereto.

According to an embodiment, the electronic device 200 may include a substantially opaque rear plate 211. In an embodiment, the rear plate 211 may form at least a portion of the second surface 200B. In an embodiment, the rear plate 211 may be formed of coated or colored glass, ceramic, polymer, metal (e.g., aluminum, stainless steel (STS), or magnesium), or a combination of at least two of the materials.

According to an embodiment, the electronic device 200 may include a lateral surface bezel structure (or a lateral surface member) 218 (e.g., a side wall 241 of a frame 240 of FIG. 3). In an embodiment, the lateral surface bezel structure 218 may form at least a portion of the third surface 200C of the electronic device 200 by being coupled to the front plate 202 and/or the rear plate 211. For example, the lateral surface bezel structure 218 may form the entire third surface 200C of the electronic device 200, and in an embodiment, the lateral surface bezel structure 218 may form the third surface 200C of the electronic device 200 together with the front plate 202 and/or the rear plate 211.

In an embodiment (not illustrated), in case that the third surface 200C of the electronic device 200 is partially formed by the front plate 202 and/or the rear plate 211, the front plate 202 and/or the rear plate 211 may include a region that is seamlessly extended by being bent toward the rear plate 211 and/or the front plate 202 at its periphery. For example, the extended region of the front plate 202 and/or the rear plate 211 may be positioned at both ends of a long edge of the electronic device 200, but is not limited by the above-described example.

In an embodiment, the lateral surface bezel structure 218 may include metal and/or a polymer. In an embodiment, the rear plate 211 and the lateral surface bezel structure 218 may be integrally formed, and may include the same material (e.g., a metal material such as aluminum), but are not limited thereto. For example, the rear plate 211 and the lateral surface bezel structure 218 may be formed in a separate configuration and/or may include a different material.

In an embodiment, the electronic device 200 may include at least one of a display 201, audio modules 203, 204, and 207, a sensor module (not illustrated), camera modules 205, 212, and 213, a key input device 217, a light emitting element (not illustrated), and/or a connector hole 208. In an embodiment, the electronic device 200 may omit at least one (e.g., the key input device 217 or the light emitting element (not illustrated)) of the components, or may additionally include another component.

In an embodiment, the display 201 (e.g., the display module 160 of FIG. 1) may be visually exposed through a large portion of the front plate 202. For example, at least a portion of the display 201 may be visible through the front plate 202 forming the first surface 200A. In an embodiment, the display 201 may be disposed on a back surface of the front plate 202.

In an embodiment, an outer shape of the display 201 may be formed generally the same as an outer shape of the front plate 202 adjacent to the display 201. In an embodiment, in order to expand an area in which the display 201 is visually exposed, a distance between an outer periphery of the display 201 and an outer periphery of the front plate 202 may be formed generally the same.

In an embodiment, the display 201 (or the first surface 200A of the electronic device 200) may include a screen display region 201A. In an embodiment, the display 201 may provide visual information to a user through the screen display region 201A. In the illustrated embodiment, when the first surface 200A is viewed frontally, the screen display region 201A is illustrated to be spaced apart from an outer periphery of the first surface 200A and positioned inside the first surface 200A, but is not limited thereto. In another embodiment, when the first surface 200A is viewed frontally, at least a portion of a periphery of the screen display region 201A may also substantially coincide with a periphery of the first surface 200A (or the front plate 202).

In an embodiment, the screen display region 201A may include a sensing region 201B configured to obtain biometric information of the user. Herein, the meaning of "the screen display region 201A includes the sensing region 201B" may be understood as that at least a portion of the sensing region 201B may be overlapped on the screen display region 201A. For example, the sensing region 201B, like another region of the screen display region 201A, may mean a region capable of displaying the visual information by the display 201 and additionally obtaining the biometric information (e.g., fingerprint) of the user. In an embodiment, the sensing region 201B may be formed in the key input device 217.

In an embodiment, the display 201 may include a region in which a first camera module 205 (e.g., the camera module 180 of FIG. 1) is positioned. In an embodiment, an opening is formed in the region of the display 201, and the first camera module 205 (e.g., a punch hole camera) may be at least partially disposed in the opening to face the first surface 200A. For example, the screen display region 201A may surround at least a portion of a periphery of the opening. In an embodiment, the first camera module 205 (e.g., an under display camera (UDC)) may be disposed under the display 201 to overlap with the region of the display 201. For example, the display 201 may provide the visual information to the user through the region, and additionally, the first camera module 205 may obtain an image corresponded to a direction toward the first surface 200A through the region of the display 201.

In an embodiment, the display 201 may be coupled with or disposed adjacent to touch sensing circuitry, a pressure sensor capable of measuring a strength (pressure) of a touch, and/or a digitizer that detects a magnetic field-type stylus pen.

In an embodiment, the audio modules 203, 204, and 207 (e.g., the audio module 170 of FIG. 1) may include microphone holes 203 and 204 and a speaker hole 207.

In an embodiment, the microphone holes 203 and 204 may include a first microphone hole 203 formed in a partial region of the third surface 200C and a second microphone hole 204 formed in a partial region of the second surface 200B. The microphone (not illustrated) for obtaining an external sound may be disposed inside the microphone holes 203 and 204. The microphone may include a plurality of microphones to detect a direction of sound.

In an embodiment, the second microphone hole 204 formed in the partial region of the second surface 200B may be disposed adjacent to the camera modules 205, 212, and 213. For example, the second microphone hole 204 may obtain sound according to an operation of the camera modules 205, 212, and 213. However, it is not limited thereto.

In an embodiment, the speaker hole 207 may include an external speaker hole 207 and a receiver hole for a call (not illustrated). The external speaker hole 207 may be formed on a portion of the third surface 200C of the electronic device 200. In an embodiment, the external speaker hole 207 may be implemented as a hole with the microphone hole 203. Although not illustrated, the receiver hole for a call (not illustrated) may be formed on another portion of the third surface 200C. For example, the receiver hole for a call may be formed on an opposite side of the external speaker hole 207 on the third surface 200C. For example, based on illustration of FIG. 2, the external speaker hole 207 may be formed on the third surface 200C corresponding to a lower end of the electronic device 200, and the receiver hole for a call may be formed on the third surface 200C corresponding to an upper end of the electronic device 200. However, it is not limited thereto, and in an embodiment, the receiver hole for a call may also be formed at a position other than the third surface 200C. For example, the receiver hole for a call may also be formed by a separated space between the front plate 202 (or the display 201) and the lateral surface bezel structure 218.

In an embodiment, the electronic device 200 may include at least one speaker (not illustrated) configured to output sound to an outside of the housing 230 through the external speaker hole 207 and/or the receiver hole for a call (not illustrated).

In an embodiment, the sensor module (not illustrated) (e.g., the sensor module 176 of FIG. 1) may generate an electrical signal or a data value corresponding to an internal operating state or an external environmental state of the electronic device 200. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera modules 205, 212, and 213 (e.g., the camera module 180 of FIG. 1) may include a first camera module 205 disposed to face the first surface 200A of the electronic device 200, and a second camera module 212 disposed to face the second surface 200B of the electronic device 200 and a flash 213.

In an embodiment, the second camera module 212 may include a plurality of cameras (e.g., a dual camera, a triple camera, or a quad camera). However, the second camera module 212 is not necessarily limited to including the plurality of cameras, and may also include a camera.

In an embodiment, the first camera module 205 and the second camera module 212 may include one or a plurality of lenses, an image sensor, and/or an image signal processor.

In an embodiment, the flash 213 may include, for example, a light emitting diode or a xenon lamp. In an embodiment, two or more lenses (an infrared camera, wide-angle and telephoto lens) and image sensors may be disposed on a surface of the electronic device 200.

In an embodiment, the key input device 217 (e.g., the input module 150 of FIG. 1) may be disposed on the third surface 200C of the electronic device 200. In an embodiment, the electronic device 200 may not include a portion or all of the key input device 217, and the key input device 217 that is not included may be implemented in another form such as a soft key on the display 201.

In an embodiment, the connector hole 208 may be formed on the third surface 200C of the electronic device 200 so that a connector of an external device may be accommodated. A connection terminal (e.g., the connection terminal 178 of FIG. 1) electrically connected to the connector of the external device may be disposed in the connector hole 208. The electronic device 200 according to an embodiment may include an interface module (e.g., the interface 177 of FIG. 1) for processing an electrical signal transmitted and received through the connection terminal.

In an embodiment, the electronic device 200 may include the light emitting element (not illustrated). For example, the light emitting element (not illustrated) may be disposed on the first surface 200A of the housing 230. The light emitting element (not illustrated) may provide state information of the electronic device 200 in an optical form. In an embodiment, the light emitting element (not illustrated) may provide a light source linked with an operation of the first camera module 205. For example, the light emitting element (not illustrated) may include an LED, an IR LED, and/or the xenon lamp.

FIG. 3 is an exploded perspective view of an exemplary electronic device according to an embodiment.

Hereinafter, an overlapping description with respect to a configuration having the same reference code as the above-described configuration will be omitted.

Referring to FIG. 3, according to an embodiment, an electronic device 200 may include a frame 240, a first printed circuit board 250, a second printed circuit board 252, a cover plate 260, and a battery 270.

In an embodiment, the frame 240 may include a side wall 241 forming an exterior (e.g., the third surface 200C of FIG. 2) of the electronic device 200 and a support portion 243 extending inside from the side wall 241. In an embodiment, the frame 240 may be disposed between a display 201 and a rear plate 211. In an embodiment, the side wall 241 of the frame 240 may surround a space between the rear plate 211 and a front plate 202 (and/or the display 201), and the support portion 243 of the frame 240 may extend from the side wall 241 in the space.

In an embodiment, the frame 240 may support or accommodate other components included in the electronic device 200. For example, the display 201 may be disposed on a surface of the frame 240 facing in a direction (e.g., a +z direction), and the display 201 may be supported by the support portion 243 of the frame 240. In an embodiment, the first printed circuit board 250, the second printed circuit board 252, the battery 270, and a second camera module 212 may be disposed on another surface facing a direction (e.g., a -z direction) opposite to the direction of the frame 240. The first printed circuit board 250, the second printed circuit board 252, the battery 270, and the second camera module 212 may be seated in a recess, respectively, defined by the side wall 241 and/or the support portion 243 of the frame 240.

In an embodiment, the first printed circuit board 250, the second printed circuit board 252, and the battery 270 may be coupled to the frame 240, respectively. For example, the first printed circuit board 250 and the second printed circuit board 252 may be fixedly disposed in the frame 240 through a coupling member such as a screw. For example, the battery 270 may be fixedly disposed in the frame 240 through an adhesive member (e.g., a double-sided tape). However, it is not limited by the above-described example.

In an embodiment, the cover plate 260 may be disposed between the first printed circuit board 250 and the rear plate 211. In an embodiment, the cover plate 260 may be disposed on the first printed circuit board 250. For example, the cover plate 260 may be disposed on a surface of the first printed circuit board 250 facing the -z direction.

In an embodiment, the cover plate 260 may at least partially overlap the first printed circuit board 250 based on a z-axis. In an embodiment, the cover plate 260 may cover at least a partial region of the first printed circuit board 250. Through this, the cover plate 260 may protect the first printed circuit board 250 from a physical impact or prevent a connector coupled to the first printed circuit board 250 from being separated.

In an embodiment, the cover plate 260 may be fixedly disposed in the first printed circuit board 250 through the coupling member (e.g., the screw), or may be coupled to the frame 240 together with the first printed circuit board 250 through the coupling member.

In an embodiment, the display 201 may be disposed between the frame 240 and the front plate 202. For example, the front plate 202 may be disposed on a side (e.g., a +z direction) of the display 201, and the frame 240 may be disposed on another side (e.g., a -z direction).

In an embodiment, the front plate 202 may be coupled to the display 201. For example, the front plate 202 and the display 201 may be adhered to each other through an optical adhesive member (e.g., optically clear adhesive (OCA) or optically clear resin (OCR)) interposed therebetween.

In an embodiment, the front plate 202 may be coupled to the frame 240. For example, the front plate 202 may include an outer portion extending outside the display 201 when viewed in the z-axis direction, and may be adhered to the frame 240 through the adhesive member (e.g., the double-sided tape) disposed between the outer portion of the front plate 202 and the frame 240 (e.g., the side wall 241). However, it is not limited by the above-described example.

In an embodiment, the first printed circuit board 250 and/or the second printed circuit board 252 may be equipped with a processor (e.g., the processor 120 of FIG. 1), memory (e.g., the memory 130 of FIG. 1), and/or an interface (e.g., the interface 177 of FIG. 1). For example, the processor may include one or more of a central processing unit, an application processor, a graphics processing unit, an image signal processor, a sensor hub processor, or a communication processor. For example, the memory may include volatile memory or nonvolatile memory. For example, the interface may include a high definition multimedia interface (HDMI), a universal serial bus (USB) interface, an SD card interface, and/or an audio interface. The interface may electrically or physically connect the electronic device 200 to an external electronic device, and may include a USB connector, an SD card/a multimedia card (MMC) connector, or an audio connector. In an embodiment, the first printed circuit board 250 and the second printed circuit board 252 may be operatively or electrically connected to each other through a connecting member (e.g., a flexible printed circuit board).

In an embodiment, the battery 270 (e.g., the battery 189 of FIG. 1) may supply power to at least one component of the electronic device 200. For example, the battery 270 may include a rechargeable secondary battery or a fuel cell. At least a portion of the battery 270 may be disposed substantially on the same plane with the first printed circuit board 250 and/or the second printed circuit board 252.

According to an embodiment, the electronic device 200 may include an antenna module (not illustrated) (e.g., the antenna module 197 of FIG. 1). In an embodiment, the antenna module may be disposed between the rear plate 211 and the battery 270. For example, the antenna module may include a near field communication (NFC) antenna, a wireless charging antenna, and/or a magnetic secure transmission (MST) antenna. For example, the antenna module may perform short-range communication with an external device or wirelessly transmit and receive the power with the external device.

In an embodiment, a first camera module 205 (e.g., a front camera) may be disposed at least a portion (e.g., the support portion 243) of the frame 240 so that a lens may receive external light through a partial region (e.g., a camera region 237) of the front plate 202 (e.g., the front surface 200A of FIG. 2).

In an embodiment, the second camera module 212 (e.g., a rear camera) may be disposed between the frame 240 and the rear plate 211. In an embodiment, the second camera module 212 may be electrically connected to the first printed circuit board 250 through a connecting member (e.g., a connector). In an embodiment, the second camera module 212 may be disposed so that a lens may receive external light through a camera region 284 of the rear plate 211 of the electronic device 200.

In an embodiment, the camera region 284 may be formed on an outer surface (e.g., the rear surface 200B of FIG. 2) of the rear plate 211. In an embodiment, the camera region 284 may be at least partially transparently formed so that the external light may be incident on the lens of the second camera module 212. In an embodiment, at least a portion of the camera region 284 may protrude from the outer surface of the rear plate 211 to a predetermined height. However, it is not limited thereto, and in an embodiment, the camera region 284 may form substantially the same plane as the outer surface of the rear plate 211.

In an embodiment, a housing (e.g., the housing 230 of FIG. 2) of the electronic device 200 may mean a configuration or a structure forming at least a portion of the exterior of the electronic device 200. In this respect, at least a portion of the front plate 202, the frame 240, and/or the rear plate 211 forming the exterior of the electronic device 200 may be referred to as the housing 230 of the electronic device 200.

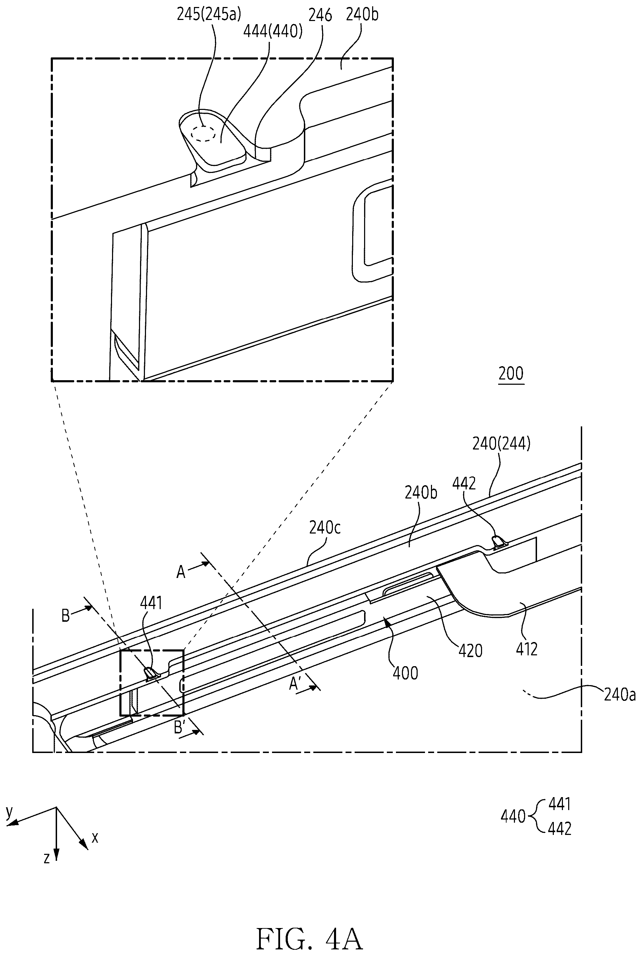

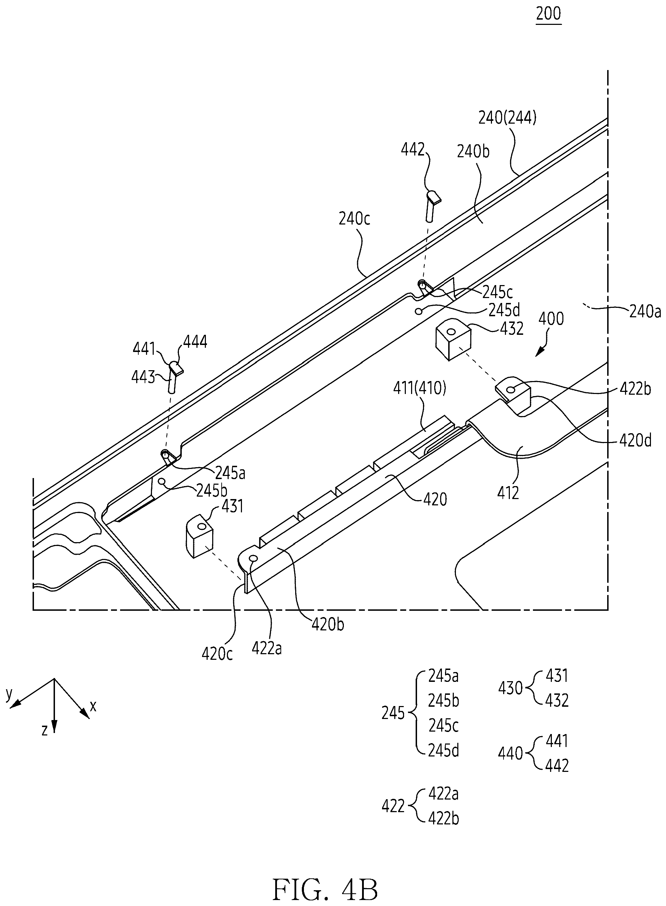

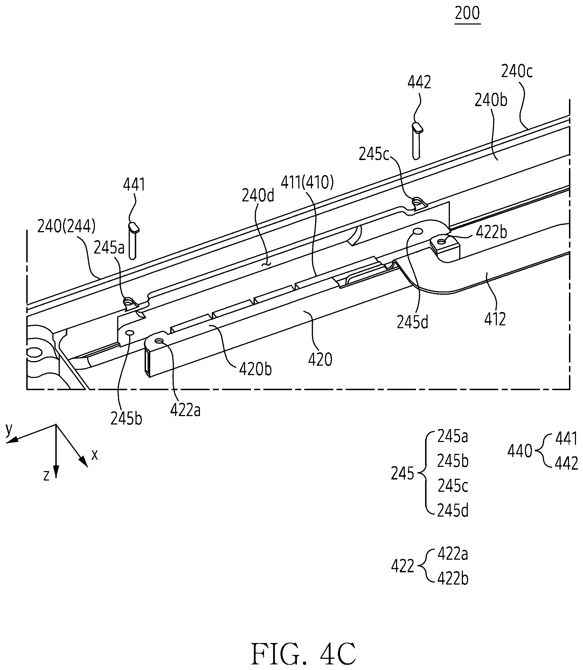

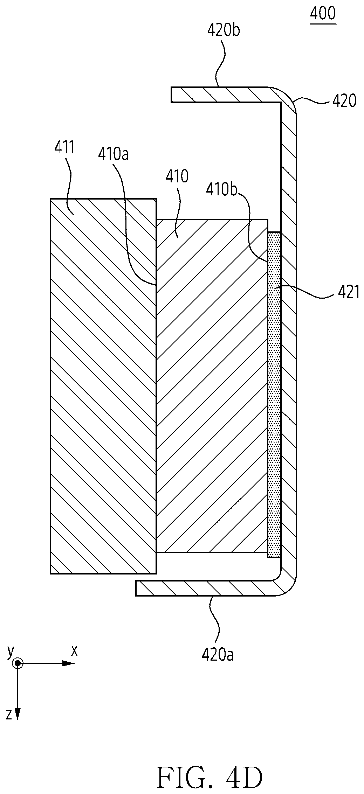

FIG. 4A is a perspective view of an exemplary frame and an antenna module according to an embodiment, FIG. 4B is an exploded perspective view of an exemplary frame and an antenna module according to an embodiment, FIG. 4C illustrates an example in which an exemplary frame and an antenna module are coupled according to an embodiment, and FIG. 4D is a cross-sectional view illustrating an example of an exemplary electronic device cut along line A-A' of FIG. 4A according to an embodiment.

Referring to FIGS. 4A, 4B, 4C, and 4D, according to an embodiment, an exemplary electronic device 200 may include a frame 240 and/or an antenna module 400. According to an embodiment, the antenna module 400 may include a third printed circuit board 410, a conductive bracket 420, at least one conductive deformation member 430, and/or at least one conductive pin 440. According to an embodiment, the conductive pin 440 may include a parallel pin, a taper pin, a split pin, a spring pin, and/or a pogo pin. Hereinafter, a structure of the electronic device 200 will be described with respect to the antenna module 400, but embodiments are not limited thereto. For example, a following description may be applied substantially the same to a module including another electronic component other than the antenna module 400. For example, the antenna module 400 may be replaced with a key button module for receiving a physical input of a user.

According to an embodiment, the frame 240 may provide a space in which components of the electronic device 200 may be disposed. The frame 240 may support the components of the electronic device 200. For example, a side 240a of the frame 240 may support a display (e.g., the display 201 of FIGS. 2 and 3). The display 201 may be disposed on the side 240a of the frame 240. Another side 240b of the frame 240 may be opposite to the side 240a of the frame 240. A direction (e.g., a -z direction) in which the another side 240b of the frame 240 faces may be opposite to a direction (e.g., a +z direction) in which the side 240a of the frame 240 faces. The another side 240b of the frame 240 may support a rear plate (e.g., the rear plate 211 of FIGS. 2 and 3). The rear plate 211 may be disposed on the another side 240b of the frame 240. The lateral side 240c of the frame 240 may connect the side 240a of the frame 240 and the another side 240b of the frame 240. The lateral side 240c of the frame 240 may be disposed between the side 240a of the frame 240 and the another side 240b of the frame 240. For example, the lateral side 240c of the frame 240 may be exposed to an outside of the electronic device 200. For example, the lateral surface 240c of the frame 240 may provide (or define, or form) an outer lateral side of the electronic device 200. However, it is not limited thereto. For example, the lateral side 240c of the frame 240 may not be exposed to the outside of the electronic device 200 by being covered by a lateral surface bezel structure (e.g., the lateral surface bezel structure 218 of FIG. 3). The frame 240 may include an opening 240d. The opening 240d may penetrate the frame 240. The opening 240d may connect an outside of the frame 240 and an inside of the frame 240. For example, the opening 240d may penetrate the lateral side 240c of the frame 240.

According to an embodiment, at least a portion of the frame 240 may include a conductive material. For example, the frame 240 may include a conductive portion 244 including the conductive material. The conductive portion 244 may define at least a portion of the frame 240. For example, the conductive portion 244 may mean the portion of the frame 240 including the conductive material among portions of the frame 240. For example, the conductive portion 244 may include the side 240a of the frame 240, the another side 240b of the frame 240, the lateral side 240c of the frame 240, and/or the opening 240d of the frame 240. For example, the conductive portion 244 may provide (or form, or define) the side 240a of the frame 240, the another side 240b of the frame 240, the lateral side 240c of the frame 240, and/or the opening 240d of the frame 240. The conductive portion 244 may accommodate the antenna module 400. The antenna module 400 may be disposed on the conductive portion 244. The antenna module 400 may be disposed in the conductive portion 244. For example, the conductive portion 244 may surround (or wrap) the antenna module 400. According to an embodiment, the conductive portion 244 may include at least one through-hole 245.

According to an embodiment, the at least one through-hole 245 may penetrate at least a portion of the conductive portion 244. The at least one through-hole 245 may be penetrated by the at least one conductive pin 440. The at least one through-hole 245 may accommodate the at least one conductive pin 440. According to an embodiment, the number of the at least one through-hole 245 may be two or more. For example, the at least one through-hole 245 may include a first through-hole 245a, a second through-hole 245b, a third through-hole 245c, and/or a fourth through-hole 245d spaced apart from each other (or separated from each other). The first through-hole 245a may penetrate the another side 240b of the frame 240. The second through-hole 245b may be spaced apart from the first through-hole 245a along a first direction (e.g., a +z direction). For example, a portion of the conductive bracket 420 and/or the at least one conductive deformation member 430 may be disposed between the first through-hole 245a and the second through-hole 245b. The third through-hole 245c may penetrate the another side 240b of the frame 240. The third through-hole 245c may be spaced apart from the first through-hole 245a along a second direction (e.g., a -y direction). For example, a distance between the third through-hole 245c and the first through-hole 245a to the second direction (e.g., the -y direction) may be greater than a width of the third printed circuit board 410. The fourth through-hole 245d may be spaced apart from the third through-hole 245c along the first direction (e.g., the +z direction). For example, another portion of the conductive bracket 420 and/or the at least one conductive deformation member 430 may be disposed between the third through-hole 245c and the fourth through-hole 245d. However, it is not limited thereto. For example, a portion of the first through-hole 245a, the second through-hole 245b, the third through-hole 245c, and/or the fourth through-hole 245d may be omitted (or removed). For example, at least one of the second through-hole 245b and/or the fourth through-hole 245d may be omitted (or removed).

Referring to FIG. 4D, according to an embodiment, the third printed circuit board 410 may be disposed in the frame 240. The third printed circuit board 410 may be disposed on the frame 240. The third printed circuit board 410 may be disposed in the conductive portion 244. The third printed circuit board 410 may include an antenna radiator 411 and a flexible printed circuit board 412. The antenna radiator 411 may form a directional beam. For example, the antenna radiator 411 may include a plurality of antenna elements (not illustrated) for forming the directional beam, but is not limited thereto. For example, the antenna radiator 411 may support communication in a high frequency band (e.g., mmWave). The antenna radiator 411 may be disposed on a first surface 410a of the third printed circuit board 410. The antenna radiator 411 may be formed (or defined) on the first surface 410a of the third printed circuit board 410. The antenna radiator 411 may be supported by the first surface 410a. The flexible printed circuit board 412 may electrically connect the third printed circuit board 410 and another electronic component in the electronic device 200. For example, the flexible printed circuit board 412 may electrically connect the first printed circuit board (e.g., the first printed circuit board 250 of FIG. 2) including the processor (e.g., the processor 120 of FIG. 1) and the third printed circuit board 410. For example, an end of the flexible printed circuit board 412 may be connected to the third printed circuit board 410, and another end of the flexible printed circuit board 412 may be connected to the first printed circuit board 250.

According to an embodiment, the conductive bracket 420 may provide electrical ground of the antenna module 400. The conductive bracket 420 may provide the electrical ground to the antenna radiator 411. For example, the conductive bracket 420 may be electrically connected to a ground layer included in the third printed circuit board 410. For example, the conductive bracket 420 may include a conductive material to be electrically connected to the ground layer of the third printed circuit board 410. A conductive attachment member 421 may be disposed (or interposed) between the third printed circuit board 410 and the conductive bracket 420. The conductive attachment member 421 may electrically connect the ground layer of the third printed circuit board 410 to the conductive bracket 420 by being disposed (or interposed) between the conductive bracket 420 and a second surface 410b. According to an embodiment, the conductive bracket 420 may support the third printed circuit board 410. For example, at least a portion of the conductive bracket 420 may be disposed on the second surface 410b of the third printed circuit board 410. The conductive bracket 420 may accommodate the third printed circuit board 410. The conductive bracket 420 may surround (or wrap) at least a portion of the third printed circuit board 410. For example, the conductive bracket 420 may include a first cover surface 420a and a second cover surface 420b surrounding the third printed circuit board 410, and/or the conductive deformation member 430. The first cover surface 420a may face a first direction (e.g., a +z direction). The first cover surface 420a may have a shape extending along a second direction (e.g., a -y direction). As the first cover surface 420a extends along the second direction (e.g., the -y direction), the first cover surface 420a may cover the at least one deformation member 430 and the third printed circuit board 410. The second cover surface 420b may be opposite to the first cover surface 420a. For example, a direction in which the second cover surface 420b faces may face a direction (e.g., a -z direction) opposite to the first direction (e.g., the +z direction) in which the first cover surface 420a faces. The second cover surface 420b may have a shape extending along the second direction (e.g., the -y direction). As the second cover surface 420b extends along the second direction (e.g., the -y direction), the second cover surface 420b may cover the at least one deformation member 430 and the third printed circuit board 410. The at least one deformation member 430 and the third printed circuit board 410 may be covered by the first cover surface 420a and the second cover surface 420b by being disposed between the first cover surface 420a and the second cover surface 420b.

According to an embodiment, the conductive bracket 420 may include at least one insertion hole 422. The at least one insertion hole 422 may penetrate at least a portion of the conductive bracket 420. The at least one insertion hole 422 may accommodate the at least one conductive pin 440. The at least one conductive pin 440 may be inserted into the at least one insertion hole 422. The number of the at least one insertion hole 422 may be two or more. For example, the at least one insertion hole 422 may include a first insertion hole 422a and/or a second insertion hole 422b spaced apart from each other. The first insertion hole 422a may penetrate the second cover surface 420b. For example, the first insertion hole 422a may correspond to the first through-hole 245a. The second insertion hole 422b may penetrate the second cover surface 420b. The second insertion hole 422b may be spaced apart from the first insertion hole 422a along the second direction (e.g., the -y direction). The second insertion hole 422b may correspond to the third through-hole 245c. However, it is not limited thereto. For example, the at least one insertion hole 422 may include only one of the first insertion hole 422a and the second insertion hole 422b. For example, in addition to the first insertion hole 422a and the second insertion hole 422b, the at least one insertion hole 422 may further include one or more insertion holes penetrating the first cover surface 420a.

According to an embodiment, the at least one conductive deformation member 430 may electrically connect the conductive portion 244 and the conductive bracket 420. For example, the at least one conductive deformation member 430 may include a conductive material for electrically connecting the conductive portion 244 and the conductive bracket 420. For example, the at least one conductive deformation member 430 may be disposed between the conductive bracket 420 and the conductive portion 244. According to an embodiment, the at least one conductive deformation member 430 may be deformable. For example, the at least one conductive deformation member 430 may include an elastically deformable material (e.g., rubber, a conductive foam gasket, conductive fiber, a metal foil, and/or silicon), but is not limited thereto. The at least one conductive deformation member 430 may be disposed in the conductive bracket 420. The at least one conductive deformation member 430 may be disposed on the conductive bracket 420. The at least one conductive deformation member 430 may be surrounded (or wrapped) by the conductive bracket 420. For example, the at least one conductive deformation member 430 may be disposed on at least one of both ends 420c and 420d of the conductive bracket 420. For example, the at least one conductive deformation member 430 may include a first conductive deformation member 431 and/or a second conductive deformation member 432. The first conductive deformation member 431 may be disposed on the end 420c of the conductive bracket 420. A portion of the first conductive deformation member 431 may be exposed to an outside of the conductive bracket 420. The second conductive deformation member 432 may be spaced apart from the first conductive deformation member 431. For example, the second conductive deformation member 432 may be spaced apart from the first conductive deformation member 431 along the second direction (e.g., the -y direction). For example, the second conductive deformation member 432 may be disposed on the another end 420d of the conductive bracket 420 opposite to the end 420c of the conductive bracket 420. The third printed circuit board 410 may be disposed between the first conductive deformation member 431 and the second conductive deformation member 432. The third printed circuit board 410 may be disposed between the end 420c of the conductive bracket 420 and the another end 420d of the conductive bracket 420.

According to an embodiment, the at least one conductive pin 440 may penetrate the at least one through-hole 245, the conductive bracket 420, and the conductive deformation member 430. For example, the at least one conductive pin 440 may include a first conductive pin 441 and a second conductive pin 442. The first conductive pin 441 may be inserted into the first through-hole 245a, the first insertion hole 422a, and the first conductive deformation member 431. The first conductive pin 441 may penetrate the conductive portion 244 by being inserted into the first through-hole 245a. The first conductive pin 441 may penetrate the conductive bracket 420 by being inserted into the first insertion hole 422a. The first conductive pin 441 may penetrate the first conductive deformation member 431 disposed in the conductive bracket 420 by penetrating the conductive bracket 420. The second conductive pin 442 may be inserted into the third through-hole 245c, the second insertion hole 422b, and the second conductive deformation member 432. The second conductive pin 442 may penetrate the conductive portion 244 by being inserted into the third through-hole 245c. The second conductive pin 442 may penetrate the conductive bracket 420 by being inserted into the second insertion hole 422b. By penetrating the conductive bracket 420, the second conductive pin 442 may penetrate the second conductive deformation member 432 disposed in the conductive bracket 420.

According to an embodiment, the at least one conductive pin 440 may couple the antenna module 400 to the frame 240. For example, the at least one conductive pin 440 may couple the antenna module 400 to the conductive portion 244. For example, when the antenna module 400 is coupled in the conductive portion 244 of the frame 240, the third printed circuit board 410 and the conductive bracket 420 coupled to the at least one conductive deformation member 430 may be accommodated into the conductive portion 244 along a third direction (e.g., a -x direction) in which the first surface 410a of the third printed circuit board 410 faces. After the conductive bracket 420 is accommodated into the conductive portion 244, the at least one insertion hole 422 of the conductive bracket 420 may be aligned with the at least one through-hole 245. For example, the first insertion hole 422a may be aligned with the first through-hole 245a, and the second insertion hole 422b may be aligned with the third through-hole 245c. After alignment between the at least one insertion hole 422 and the at least one through-hole 245 is completed, the antenna module 400 may be coupled to the conductive portion 244 of the frame 240, as the at least one conductive pin 440 penetrates the conductive portion 244, the conductive bracket 420, and the at least one conductive deformation member 430.

According to an embodiment, at least a portion of the at least one conductive pin 440 may extend along the first direction (e.g., the +z direction). For example, at least a portion of the at least one conductive pin 440 may have a shape extending along the first direction (e.g., the +z direction). For example, the at least one conductive pin 440 may include a first extending portion 443 and a second extending portion 444. The first extending portion 443 may extend along the first direction (e.g., the +z direction). The first extending portion 443 may be inserted into the at least one through-hole 245. The first extending portion 443 may penetrate the conductive portion 244, the conductive bracket 420, and/or the at least one conductive deformation member 430. The second extending portion 444 may be connected to the first extending portion 443. The second extending portion 444 may extend along a direction distinct from the first direction (e.g., the +z direction). For example, the second extending portion 444 may be bent with respect to the first extending portion 443. The second extending portion 444 may be disposed outside the at least one through-hole 245. The second extending portion 444 may be in contact with the conductive portion 244 outside of the at least one through-hole 245. The second extending portion 444 may support coupling of the conductive portion 244 and the antenna module 400 by contacting the conductive portion 244 outside of the at least one through-hole 245. According to an embodiment, the conductive portion 244 may include at least one receiving groove 246. The at least one receiving groove 246 may correspond to the second extending portion 444. The at least one receiving groove 246 may accommodate the second extending portion 444. The at least one receiving groove 246 may be formed by another side 240b of the frame 240 being dented inside. An end of the at least one receiving groove 246 may be opened. For example, the end of the at least one receiving groove 246 may be opened toward an inside of the conductive portion 244. A direction toward the inside of the conductive portion 244 (e.g., a +x direction) may be opposite to a direction toward the outside of the conductive portion 244 (e.g., a -x direction). For example, the end of the at least one receiving groove 246 of the conductive portion 244 may be opened in a direction (e.g., the +x direction) toward the battery (the battery 270 of FIG. 3).

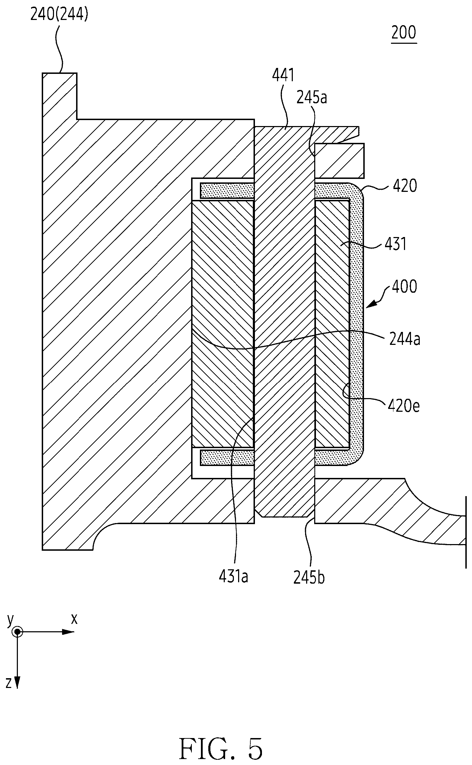

According to an embodiment, in a state penetrated by the at least one conductive pin 440, the at least one conductive deformation member 430 may be in contact with the conductive bracket 420 and the conductive portion 244 to secure performance of the antenna radiator 411. For example, a structure in which the at least one conductive deformation member 430, the conductive bracket 420, and the conductive portion 244 are in contact with each other may be described through FIG. 5.

Meanwhile, hereinafter, for convenience of a description, coupling of the at least one conductive deformation member 430, the conductive bracket 420, and the conductive portion 244 will be described based on the first through-hole 245a, the first insertion hole 422a, and the first conductive deformation member 431. However, since a structure of the antenna module 400 is symmetrical based on the third printed circuit board 410, the description of the first through-hole 245a, the first insertion hole 422a, and the first conductive deformation member 431 may be applied substantially the same to the third through-hole 245c, the second insertion hole 422b, and the second conductive deformation member 432.

FIG. 5 is a cross-sectional view illustrating an example of an exemplary electronic device cut along line B-B' of FIG. 4A according to an embodiment.

Referring to FIG. 5, according to an embodiment, when an antenna module 400 is coupled to a conductive portion 244 of a frame 240, a first conductive deformation member 431 may contact the conductive portion 244 and a conductive bracket 420. For example, the first conductive deformation member 431 may be in contact with an internal surface 244a of the conductive portion 244 and an internal surface 420e of the conductive bracket 420 facing the internal surface 244a of the conductive portion 244. The internal surface 420e of the conductive bracket 420 may face a third direction (e.g., a -x direction) in which a first surface (e.g., the first surface 410a of FIG. 4D) of a third printed circuit board 410 (e.g., the third printed circuit board 410 of FIG. 4D) faces. The internal surface 244a of the conductive portion 244 may face a direction (e.g., a +x direction) opposite to the third direction (e.g., the -x direction).

The first conductive deformation member 431 may fill a space between the conductive bracket 420 and the conductive portion 244. The first conductive deformation member 431 may completely fill the space between the internal surface 420e of the conductive bracket 420 and the internal surface 244a of the conductive portion 244. For example, a thickness of the first conductive deformation member 431 before contacting the conductive portion 244, and the conductive bracket 420 may be greater than a distance between the internal surface 420e of the conductive bracket 420 and the internal surface 244a of the conductive portion 244. The first conductive deformation member 431 may be compressed by contacting the conductive portion 244 and the conductive bracket 420.

For example, in order to secure performance of the antenna module 400 for communication with an external electronic device distinct from an electronic device 200, electrical ground for removing a noise may be required. Since as a size of a component providing antenna ground becomes smaller, the performance of the antenna module 400 becomes lower, the conductive bracket 420 may be electrically connected to the conductive portion 244 for smooth communication between the electronic device 200 and the external electronic device. In case that the first conductive deformation member 431 is spaced apart from at least one of the conductive portion 244 and the conductive bracket 420, an electrical connection between the conductive portion 244 and the conductive bracket 420 may be unstable. In case that the electrical connection between the conductive portion 244 and the conductive bracket 420 is unstable, the performance of the antenna module 400 may be decreased. Since the first conductive deformation member 431 is in contact with both the conductive portion 244 and the conductive bracket 420, the electronic device 200 according to an embodiment may provide a structure in which the electrical connection between the conductive portion 244 and the conductive bracket 420 is stable.

According to an embodiment, since the first conductive deformation member 431 is in contact with both the conductive portion 244 and the conductive bracket 420, the antenna module 400 may be stably coupled to the frame 240. For example, in case that the first conductive deformation member 431 is spaced apart from at least one of the conductive portion 244 and the conductive bracket 420, a physical coupling between the conductive bracket 420 and the conductive portion 244 may become unstable. Since the first conductive deformation member 431 is in contact with both the conductive portion 244 and the conductive bracket 420, the electronic device 200 according to an embodiment may provide a structure in which the physical connection between the conductive portion 244 and the conductive bracket 420 is a stable.

According to an embodiment, the first conductive deformation member 431 may include an internal space 431a. The internal space 431a may be penetrated by a first conductive pin 441. The internal space 431a may accommodate the first conductive pin 441. According to an embodiment, a size of a cross-sectional area of the internal space 431a before the first conductive pin 441 is inserted may be smaller than a size of a cross-sectional area of the first conductive pin 441. As the size of the cross-sectional area of the internal space 431a before the first conductive pin 441 is inserted is smaller than the size of the cross-sectional area of the first conductive pin 441, the first conductive pin 441 may be in contact with the first conductive deformation member 431. Since the first conductive pin 441 including a conductive material is in contact with the first conductive deformation member 431, the first conductive pin 441 may be electrically connected to the conductive portion 244 and the conductive bracket 420 through the first conductive deformation member 431. As the first conductive pin 441 is electrically connected to the conductive bracket 420, the performance of the antenna module 400 may be improved.

According to an embodiment, the first conductive pin 441 may be inserted into a first through-hole 245a and a second through-hole 245b. For example, the first conductive pin 441 may penetrate at least a portion of the second through-hole 245b.

As described above, according to an embodiment, the electronic device 200 may provide a structure in which the antenna module 400 may be stably coupled in the conductive portion 244 by the first conductive deformation member 431 filling the space between the conductive bracket 420 and the conductive portion 244.

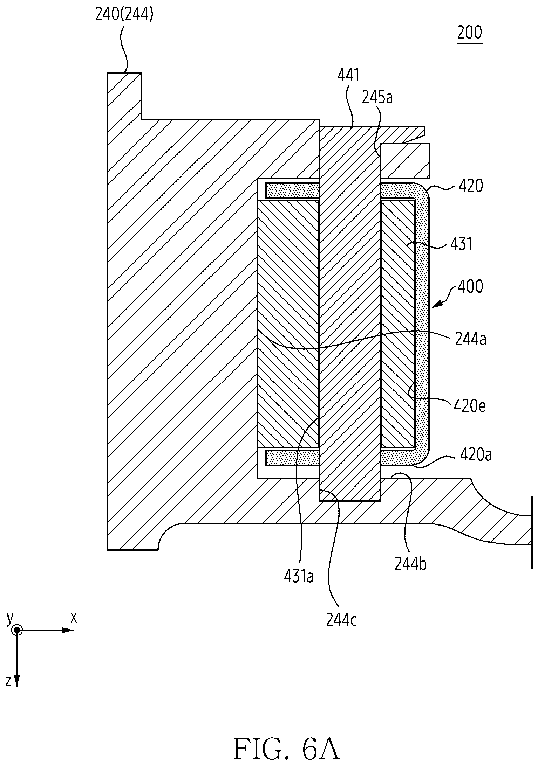

FIG. 6A is a cross-sectional view illustrating an example of cutting an exemplary electronic device according to an embodiment, and 6B is a cross-sectional view illustrating an example of cutting an exemplary electronic device according to an embodiment.

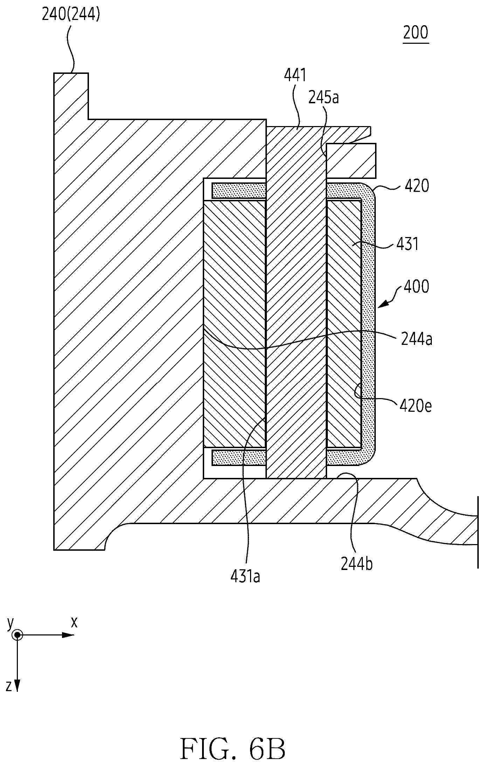

Referring to FIGS. 6A and 6B, a first conductive pin 441 may be inserted into a first through-hole 245a. A conductive portion 244 may not include a second through-hole (e.g., the second through-hole 245b of FIG. 5). For example, as the conductive portion 244 does not include the second through-hole 245b, a relationship between the first conductive pin 441 and a surface 244b of the conductive portion 244 facing a first cover side 420a of the conductive bracket 420 may be changed.

For example, referring to FIG. 6A, the conductive portion 244 may include a support groove 244c. The support groove 244c may be formed by at least a portion of the conductive portion 244 being dented inside. For example, the support groove 244c may be formed by the surface 244b of the conductive portion 244 facing the first cover surface 420a of the conductive bracket 420 being dented inward. A portion of the first conductive pin 441 penetrating the conductive bracket 420 may be accommodated (or inserted) into the support groove 244c.

For example, referring to FIG. 6B, the first conductive pin 441 may be disposed on the surface 244b of the conductive portion 244. For example, the first conductive pin 441 may be in contact with the surface 244b of the conductive portion 244, but is not limited thereto. For example, the first conductive pin 441 may be spaced apart from the surface 244b of the conductive portion 244. The first conductive pin 441 may not penetrate the surface 244b of the conductive portion 244 facing the first cover surface 420a of the conductive bracket 420. The first conductive pin 441 may not be inserted into the surface 244b of the conductive portion 244 facing the first cover surface 420a of the conductive bracket 420.

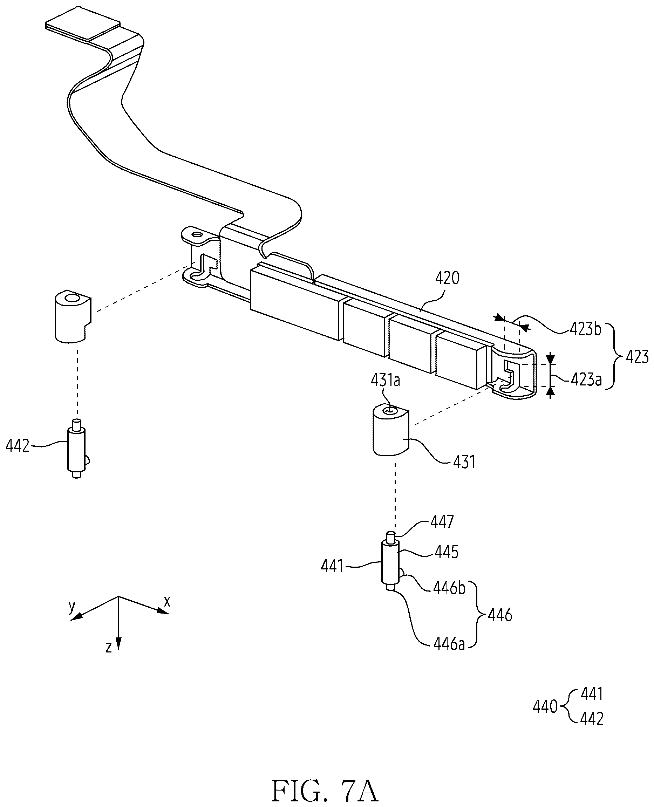

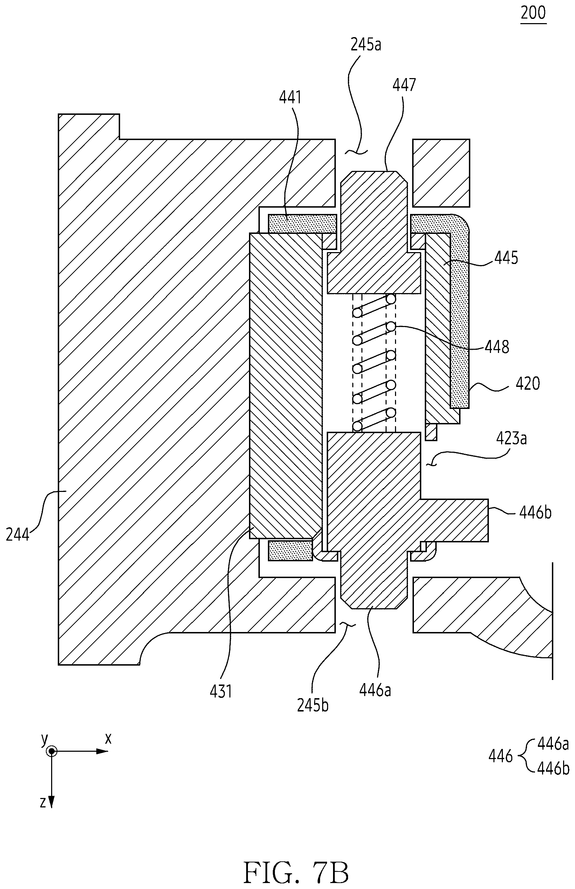

FIG. 7A is an exploded perspective view of an exemplary antenna module according to an embodiment, and FIG. 7B is a cross-sectional view illustrating an example of cutting an exemplary electronic device according to an embodiment.

Referring to FIGS. 7A and 7B, according to an embodiment, at least one conductive pin 440 may include a first body 445, a second body 446, a third body 447, and/or an elastic member 448. Hereinafter, the first body 445, the second body 446, the third body 447, and/or the elastic member 448 will be described based on a first conductive pin 441, but is not limited thereto. For example, a description of the first body 445, the second body 446, the third body 447, and/or the elastic member 448 may be applied substantially the same to a second conductive pin 442.

According to an embodiment, the first body 445 may extend along a first direction (e.g., a +z direction). The first body 445 may accommodate the second body 446, the third body 447, and/or the elastic member 448. The first body 445 may surround (or wrap) the second body 446, the third body 447, and/or the elastic member 448. The first body 445 may be disposed in a first conductive deformation member 431. For example, the first body 445 may be surrounded (or wrapped) by the first conductive deformation member 431. For example, a size of a cross-sectional area of the first body 445 may be larger than a size of the cross-sectional area of an internal space 431a of the first conductive deformation member 431.

According to an embodiment, the second body 446 may be disposed in the first body 445. The second body 446 may be surrounded (or wrapped) by the first body 445. The second body 446 may be movable with respect to the first body 445. For example, the second body 446 may be movable along the first direction (e.g., the +z direction) with respect to the first body 445 or a fourth direction (e.g., a -z direction) opposite to the first direction (e.g., the +z direction). The second body 446 may be accommodated in the first body 445 or may protrude to an outside of the first body 445 by moving with respect to the first body 445. For example, the second body 446 may be inserted into the second through-hole 245b disposed outside the first body 445 by moving along the first direction (e.g., the +z direction) with respect to the first body 445. For example, the second body 446 may be accommodated in the first body 445 by moving along the fourth direction (e.g., the -z direction) with respect to the first body 445.

According to an embodiment, the second body 446 may include a first extending portion 446a and a second extending portion 446b. The first extending portion 446a may extend along the first direction (e.g., the +z direction). The first extending portion 446a may be inserted into the second through-hole 245b by movement of the second body 446 to the first direction (e.g., the +z direction) with respect to the first body 445. The first extending portion 446a may be accommodated in the first body 445 by the movement of the second body 446 to the fourth direction (e.g., the -z direction) with respect to the first body 445. The second extending portion 446b may be bent with respect to the first extending portion 446a. For example, the second extending portion 446b may be perpendicular to the first extending portion 446a, but is not limited thereto. The second extending portion 446b may be exposed to the outside of the first body 445 (or the outside of the conductive bracket 420) independently of the movement of the second body 446 with respect to the first body 445.

According to an embodiment, the third body 447 may be disposed in the first body 445. The third body 447 may be wrapped (or surrounded) by the first body 445. The third body 447 may be movable with respect to the first body 445. For example, the third body 447 may be movable along the first direction (e.g., the +z direction) or the fourth direction (e.g., the -z direction) opposite to the first direction (e.g., the +z direction) with respect to the first body 445. The third body 447 may be accommodated into the first body 445 or may protrude to the outside of the first body 445 by moving with respect to the first body 445. For example, the third body 447 may be accommodated into the first body 445 by moving along the first direction (e.g., the +z direction) with respect to the first body 445. For example, the third body 447 may be inserted into the first through-hole 245a outside the first body 445 by moving along the fourth direction (e.g., the -z direction) with respect to the first body 445.

According to an embodiment, the elastic member 448 may provide an elastic force to the second body 446 and/or the third body 447. The elastic member 448 may restore a position of the second body 446 and/or the third body 447. The elastic member 448 may apply a force to the second body 446 and/or the third body 447 in a direction toward the outside of the conductive bracket 420. For example, the elastic member 448 may apply the force to the second body 446 in the first direction (e.g., the +z direction). For example, the elastic member 448 may apply the force to the third body 447 in the fourth direction (e.g., the -z direction). For example, the elastic member 448 may be a spring, but is not limited thereto.

Referring to FIG. 7A, according to an embodiment, the conductive bracket 420 may include at least one receiving space 423. The at least one receiving space 423 may accommodate the second extending portion 446b of the second body 446. The at least one receiving space 423 may provide a space in which the second extending portion 446b may move. The at least one receiving space 423 may penetrate the conductive bracket 420. A portion of the at least one receiving space 423 may extend along the first direction (e.g., the +z direction). For example, the at least one receiving space 423 may include a first receiving space 423a and a second receiving space 423b. The first receiving space 423a may be parallel to the first extending portion 446a. For example, the first receiving space 423a may extend along the first direction (e.g., the +z direction) which is an extending direction of the first extending portion 446a. The second receiving space 423b may be connected to the first receiving space 423a. The second receiving space 423b may be bent with respect to the first receiving space 423a. For example, the second receiving space 423b may be perpendicular with respect to the first receiving space 423a. For example, the second receiving space 423b may be bent to have a curvature with respect to the first receiving space 423a.

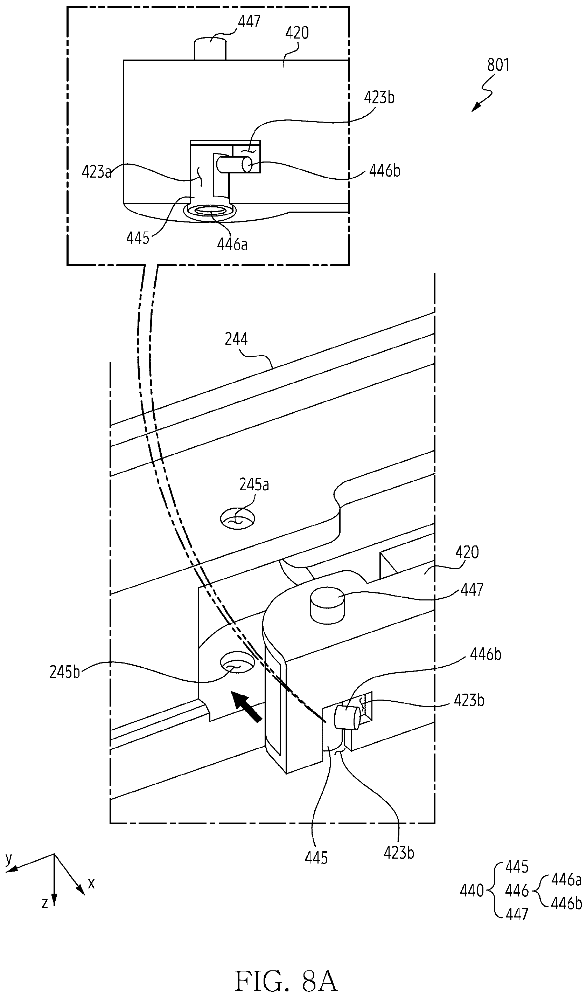

According to an embodiment, when the conductive bracket 420 is disposed in the conductive portion 244, the first conductive pin 441 may be movable with respect to the conductive bracket 420. The first conductive pin 441 may be rotatable with respect to the conductive bracket 420. By rotation of the first conductive pin 441, the second extending portion 446b may be disposed in the second receiving space 423b or in the first receiving space 423a. For example, the second extending portion 446b may be disposed in the first receiving space 423a while the first extending portion 446a protrudes outside the first body 445. For example, the second extending portion 446b may be disposed in the first receiving space 423a while the first extending portion 446a is inserted into the second through-hole 245b. For example, the second extending portion 446b may move from the first receiving space 423a to the second receiving space 423b or from the second receiving space 423b to the first receiving space 423a by the rotation of the first conductive pin 441 with respect to the conductive bracket 420, while the first extending portion 446a is accommodated in the first body 445. For example, an arrangement relationship between the second extending portion 446b and the at least one receiving space 423 while the conductive bracket 420 is disposed in the conductive portion 244 may be described through FIGS. 8A to 8C.

FIGS. 8A to 8C indicate an example in which an exemplary antenna module according to an embodiment is coupled in an exemplary conductive portion.

Referring to FIG. 8A, in a first state 801, a conductive bracket 420 may move into a conductive portion 244 along a third direction (e.g., a -x direction). A first extending portion 446a of a second body 446 may be accommodated in a first body 445. A second extending portion 446b of the second body 446 may be disposed (or accommodated) in a second receiving space 423b of a first receiving space 423a and the second receiving space 423b. The second extending portion 446b may be supported by the conductive bracket 420 while being accommodated in the second receiving space 423b. As the second extending portion 446b is supported by the conductive bracket 420, movement of the second body 446 in a first direction (e.g., a +z direction) with respect to the first body 445 may be restricted. The third body 447 may protrude to an outside of the conductive bracket 420.

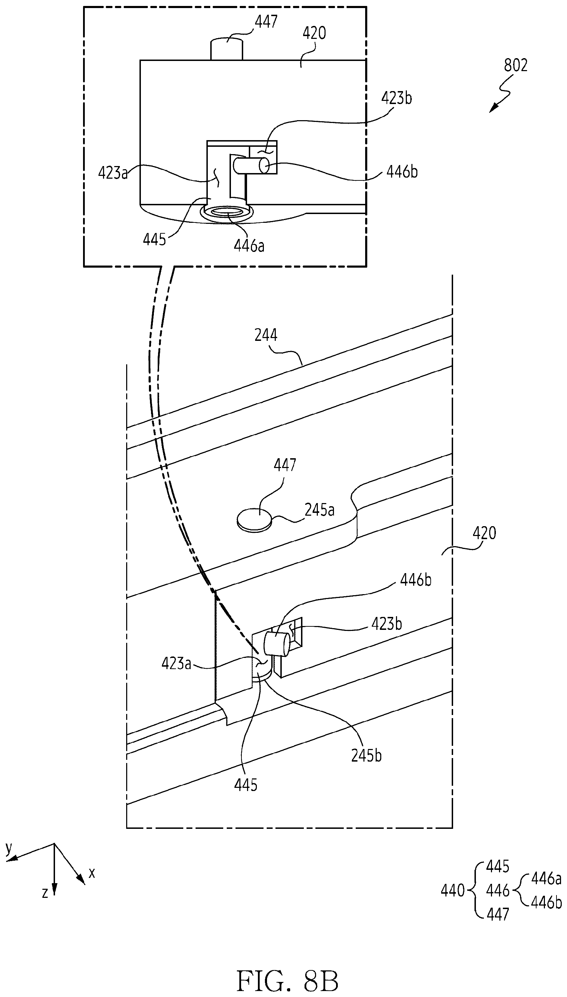

Referring to FIG. 8B, in a second state 802, the conductive bracket 420 may be disposed on the conductive portion 244. As the conductive bracket 420 is disposed in the conductive portion 244, a position of the third body 447 may correspond to a position of a first through-hole 245a. For example, the third body 447 may be inserted into the first through-hole 245a. As the conductive bracket 420 is disposed in the conductive portion 244, a position of the first extending portion 446b may correspond to a second through-hole 245b. In the second state 802, since the second extending portion 446b is supported by the conductive bracket 420 by being accommodated in the second receiving space 423b, the first extending portion 446b may not be inserted into the second through-hole 245b.

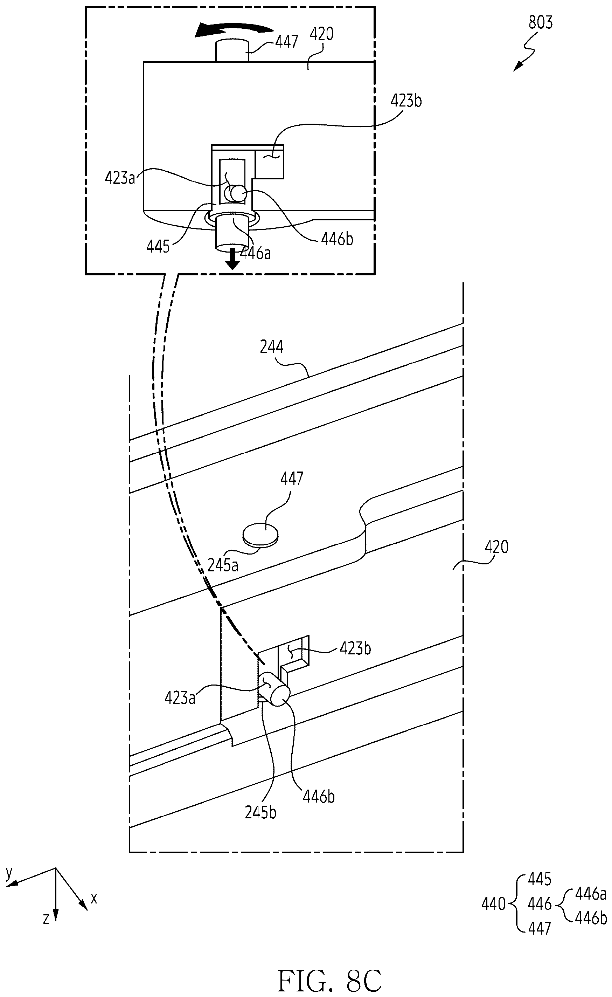

Referring to FIG. 8C, in a third state 803, the second extending portion 446b may move from the second receiving space 423b to the first receiving space 423a. For example, while changing from the second state 802 to the third state 803, the first conductive pin 441 may rotate with respect to the conductive bracket 420. For example, the second extending portion 446b may move from the second receiving space 423b to the first receiving space 423a by rotation of the first conductive pin 441 with respect to the conductive bracket 420 while the first extending portion 446a is accommodated in the first body 445. Since the second extending portion 446b is not supported by the conductive bracket 420 in the first receiving space 423a, the second body 446 may move with respect to the first body 445 along the first direction (e.g., the +z direction). As the second body 446 moves with respect to the first body 445 along the first direction (e.g., the +z direction), the first extending portion 446a may be inserted into the second through-hole 245b. As the first extending portion 446a is inserted into the second through-hole 245b and the third body 447 is inserted into the first through-hole 245a, a coupling between an antenna module 400 and the conductive portion 244 may be completed.

According to an embodiment, when the antenna module 400 is separated from the conductive portion 244, the second body 446 may move in a fourth direction (e.g., a -z direction) with respect to the first body 445. As the second body 446 moves along the fourth direction (e.g., the -z direction) with respect to the first body 445, the first extending portion 446a may be accommodated in the first body 445. As the second body 446 moves along the fourth direction (e.g., the -z direction) with respect to the first body 445, the first extending portion 446a may be disposed outside the second through-hole 245b. The second extending portion 446b may move from the first receiving space 423a to the second receiving space 423b by rotation of the first conductive pin 441 with respect to the conductive bracket 420 while the first extending portion 446a is accommodated in the first body 445. The antenna module 400 may be separated from the conductive portion 244, since the first extending portion 446a is maintained in a state spaced apart from the second through-hole 245b as the second extending portion 446b is supported by the conductive bracket 420 in the second receiving space 423b.

As described above, according to an embodiment, an electronic device 200 may provide a structure in which the antenna module 400 and the conductive portion 244 are easily coupled by the second body 446 in which at least one conductive pin 440 is movable with respect to the first body 445.

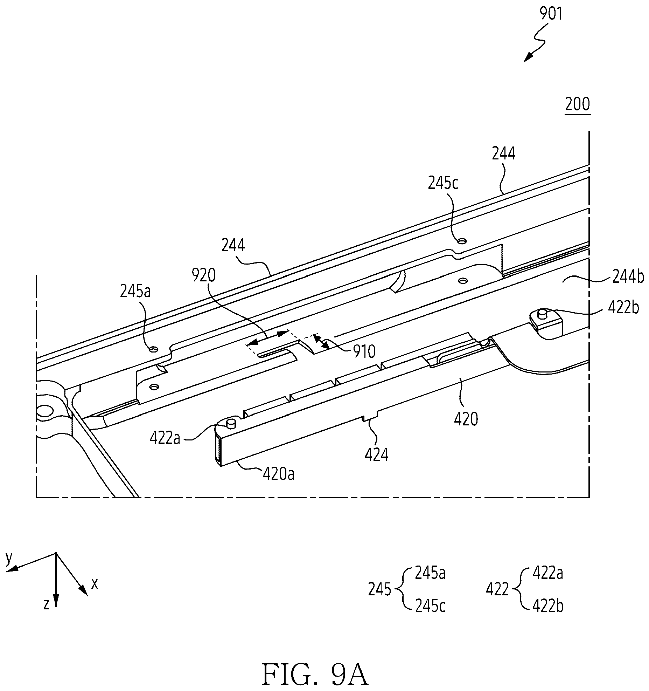

FIGS. 9A to 9C indicate an example in which an exemplary antenna module according to an embodiment is coupled in an exemplary conductive portion.

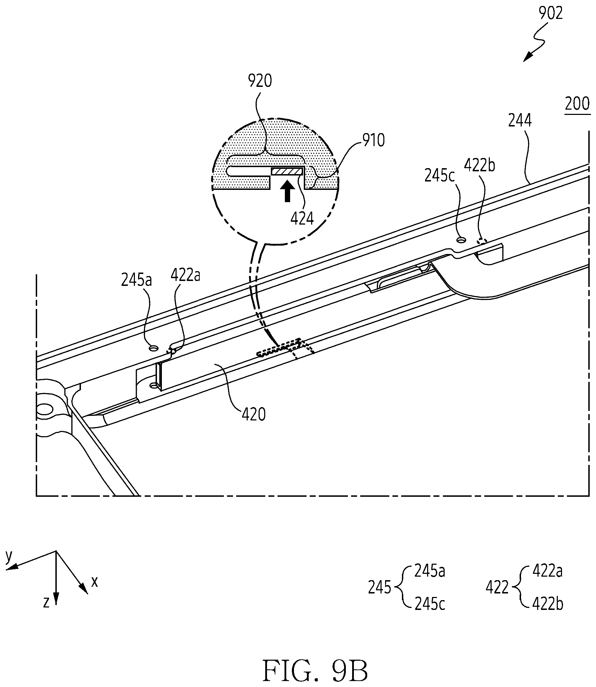

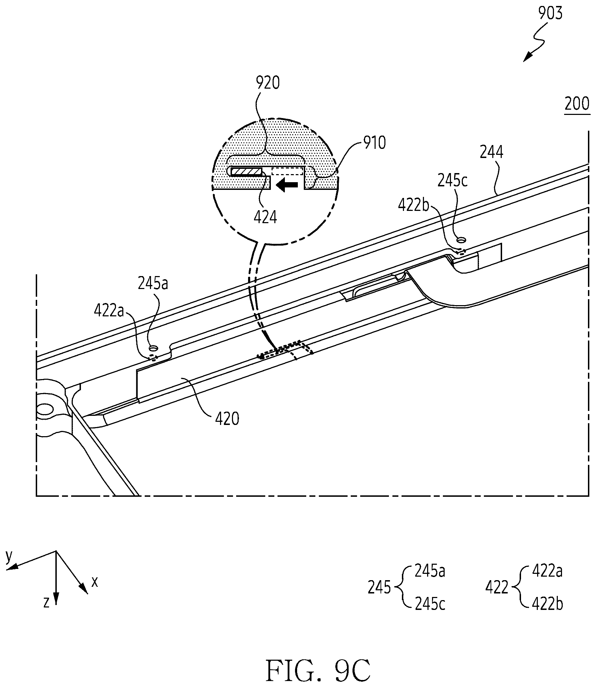

Referring to FIGS. 9A, 9B, and 9C, according to the embodiment, a conductive portion 244 may include a first coupling groove 910 and a second coupling groove 920. The first coupling groove 910 and the second coupling groove 920 may guide movement of a conductive bracket 420 while the conductive bracket 420 is coupled to the conductive portion 244. The first coupling groove 910 and the second coupling groove 920 may be disposed on a surface 244b of the conductive portion 244. For example, the first coupling groove 910 and the second coupling groove 920 may be defined (or formed) by the surface 244b of the conductive portion 244 being dented inside. The first coupling groove 910 may extend along a third direction (e.g., a -x direction). The third direction (e.g., the -x direction) may correspond to a direction in which the conductive bracket 420 moves to be coupled to the conductive portion 244. The second coupling groove 920 may be connected to the first coupling groove 910. For example, an end of the second coupling groove 920 may be connected to the first coupling groove 910. For example, another end of the second coupling groove 920 opposite to the end of the second coupling groove 920 may be closed. The second coupling groove 920 may be bent with respect to the first coupling groove 910. For example, the second coupling groove 920 may be perpendicular to the first coupling groove 910. However, it is not limited thereto. For example, the second coupling groove 920 may be inclined with respect to the first coupling groove 910 or may be bent to have a curvature with respect to the first coupling groove 910.

According to an embodiment, the conductive bracket 420 may include a coupling protrusion 424. The coupling protrusion 424 may be movable within the first coupling groove 910 and the second coupling groove 920. The coupling protrusion 424 may be disposed on a first cover surface 420a of the conductive bracket 420 facing a surface 244b of the conductive portion 244. The coupling protrusion 424 may protrude from the first cover surface 420a. For example, the coupling protrusion 424 may extend along a first direction (e.g., a +z direction) from the first cover surface 420a of the conductive bracket 420.

Referring to FIG. 9A, in a first state 901, the conductive bracket 420 may move into the conductive portion 244 along the third direction (e.g., the -x direction). As the conductive bracket 420 moves along the third direction (e.g., the -x direction), the coupling protrusion 424 of the conductive bracket 420 may move toward the first coupling groove 910.

Referring to FIG. 9B, in a second state 902, the coupling protrusion 424 may be inserted (or accommodated) into the first coupling groove 910. In a state where the coupling protrusion 424 is inserted into the first coupling groove 910, when the conductive portion 244 is viewed from above (e.g., along the first direction (e.g., the +z direction)), at least one through-hole 245 may be disposed outside the at least one insertion hole 422. In a state where the coupling protrusion 424 is inserted into an end of the second coupling groove 920, when the conductive portion 244 is viewed from above (e.g., along the first direction (e.g., the +z direction)), the first through-hole 245a may be disposed outside a first insertion hole 422a. In a state where the coupling protrusion 424 is inserted into the end of the second coupling groove 920, when the conductive portion 244 is viewed from above (e.g., along the first direction (e.g., the +z direction), the first through-hole 245a may be spaced apart from the first insertion hole 422a. In a state where the coupling protrusion 424 is inserted into the end of the second coupling groove 920, when the conductive portion 244 is viewed from above (e.g., along the first direction (e.g., the +z direction)), a third through-hole 245c may be disposed outside a second insertion hole 422b. In a state where the coupling protrusion 424 is inserted into the end of the second coupling groove 920, when the conductive portion 244 is viewed from above (e.g., along the first direction (e.g., the +z direction)), the third through-hole 245c may be spaced apart from the second insertion hole 422b.

Referring to FIG. 9C, in a third state 903, the coupling protrusion 424 may be inserted (or accommodated) into the second coupling groove 920. For example, while changing from the second state 902 to the third state 903, the conductive bracket 420 may move along a fifth direction (e.g., a +y direction) opposite to a second direction (e.g., a -y direction) in the conductive portion 244. As the conductive bracket 420 moves along the fifth direction (e.g., the +y direction), the coupling protrusion 424 may be inserted into another end of the second coupling groove 920. In a state where the coupling protrusion 424 is inserted into the another end of the second coupling groove 920, when the conductive portion 244 is viewed from above (e.g., along the first direction (e.g., the +z direction)), the first through-hole 245a may overlap with the first insertion hole 422a. In a state where the coupling protrusion 424 is inserted into the second coupling groove 920, when the conductive portion 244 is viewed from above (e.g., along the first direction (e.g., the +z direction)), a position of the first through-hole 245a may correspond to a position of the first insertion hole 422a. In a state where the coupling protrusion 424 is inserted into the another end of the second coupling groove 920, when the conductive portion 244 is viewed from above (e.g., along the first direction (e.g., the +z direction)), the third through-hole 245c may overlap with the second insertion hole 422b. In a state where the coupling protrusion 424 is inserted into the another end of the second coupling groove 920, when the conductive portion 244 is viewed from above (e.g., along the first direction (e.g., the +z direction)), the position of the third through-hole 245c may overlap a position of the second insertion hole 422b. After the first through-hole 245a overlaps the first insertion hole 422a and the third through-hole 245c overlaps the second insertion hole 422b, at least one conductive pin 440 may be inserted into the first through-hole 245a and/or the third through-hole 245c.

As described above, according to an embodiment, an electronic device 200 may provide a structure in which the conductive bracket 420 and the conductive portion 244 may be easily coupled, since the coupling protrusion 424 of the conductive bracket 420 is slidable with respect to the conductive portion 244 along the first coupling groove 910 and the second coupling groove 920.

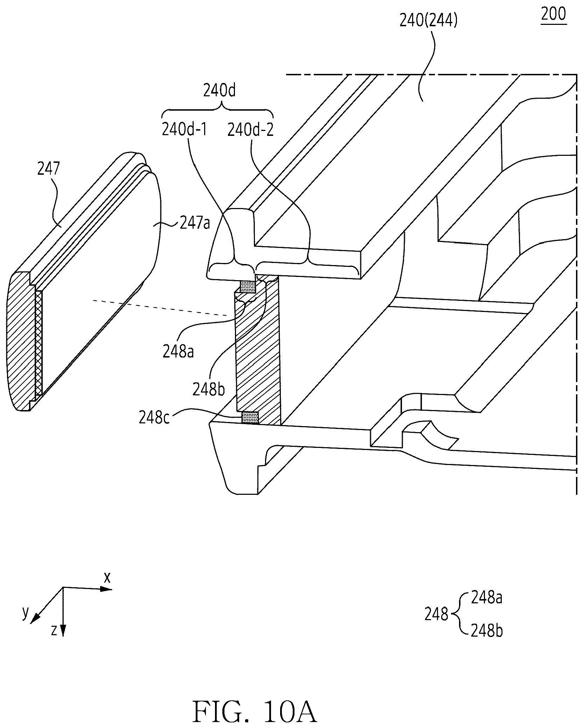

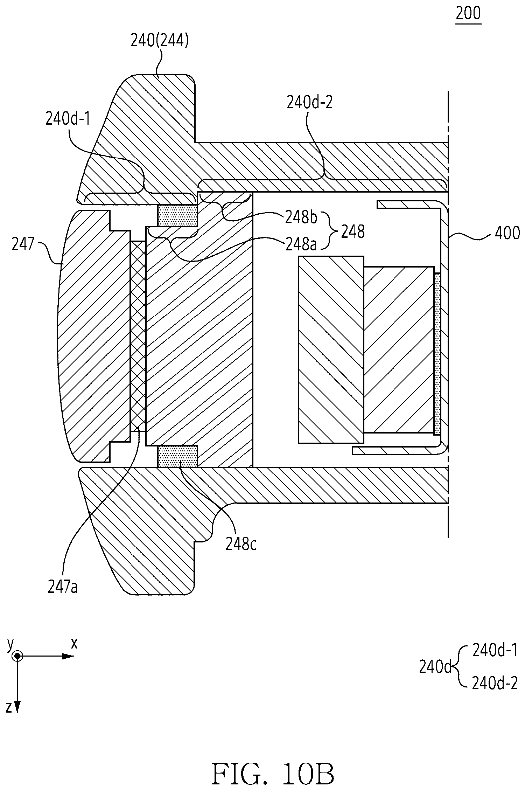

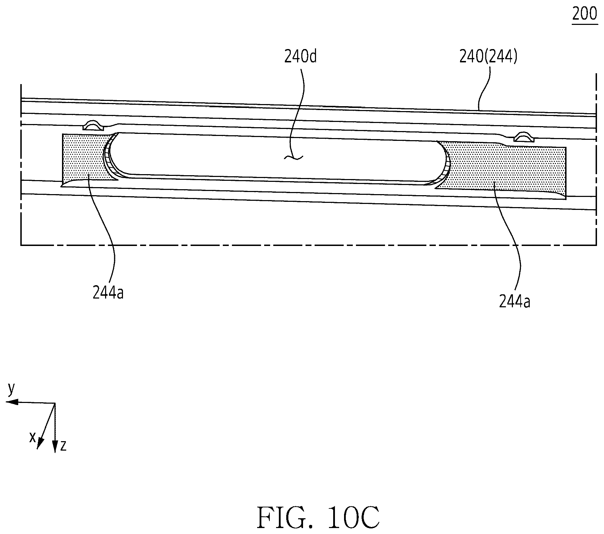

FIG. 10A is an exploded perspective view of an exemplary conductive portion according to an embodiment, FIG. 10B is a cross-sectional view of an exemplary electronic device according to an embodiment, and FIG. 10C is a diagram illustrating an opening of an exemplary conductive portion according to an embodiment.

Referring to FIGS. 10A, 10B, and 10C, according to an embodiment, an electronic device 200 may include a cover member 247 and/or a support bracket 248.

According to an embodiment, an opening 240d of a frame 240 may include a first region 240d-1 and a second region 240d-2. The first region 240d-1 may connect an outside of the frame 240 and an inside of the frame 240. The first region 240d-1 may connect an outside of the conductive portion 244 and an inside of the conductive portion 244. The second region 240d-2 may be connected to the first region 240d-1. A size of the second region 240d-2 may be larger than a size of the first region 240d-1. A width of the second region 240d-2 may be greater than a width of the first region 240d-1. According to an embodiment, the opening 240d may be formed by cutting (or penetrating) a portion of the conductive portion 244 (or the frame 240). For example, the first region 240d-1 and the second region 240d-2 may be formed by penetrating the conductive portion 244 (or the frame 240) by different tools. For example, a size of a tool for forming the first region 240d-1 may be smaller than a size of a tool for forming the second region 240d-2. For example, the tool for forming the first region 240d-1 may form the first region 240d-1 by cutting the frame 240 (or the conductive portion 244) when the frame 240 is manufactured. For example, the tool for forming the second region 240d-2 may form the second region 240d-2, and an internal surface 244a of the conductive portion 244 by cutting the frame 240 (or the conductive portion 244) when the frame 240 is manufactured.

According to an embodiment, the cover member 247 may be exposed to the outside of the frame 240. The cover member 247 may be exposed to the outside of the conductive portion 244. The cover member 247 may cover an antenna module 400. For example, the cover member 247 may be disposed in the opening 240d of the frame 240. For example, the cover member 247 may be disposed in the first region 240d-1. For example, the cover member 247 may fill at least a portion of the opening 240d. A size of the cover member 247 may correspond to the size of the first region 240d-1.

According to an embodiment, the support bracket 248 may support the cover member 247. For example, the support bracket 248 may be disposed between the cover member 247 and the antenna module 400. According to an embodiment, the support bracket 248 may include a first portion 248a and a second portion 248b. The first portion 248a may be accommodated into the first region 240d-1. The first portion 248a may be in contact with the conductive portion 244 (or the frame 240) through a first adhesive member 248c. The first portion 248a may be attached to the conductive portion 244 (or the frame 240) through the first adhesive member 248c. The first adhesive member 248c may be disposed along a periphery of the first portion 248a. The first adhesive member 248c may be disposed between the first portion 248a and the conductive portion 244 (or the frame 240). For example, the first adhesive member 248c may be formed of resin cured by an ultraviolet ray. A size of the first portion 248a may be smaller than the size of the first region 240d-1. When the support bracket 248 is disposed in the conductive portion 244 (or the frame 240), the first adhesive member 248c may be applied between the conductive portion 244 (or the frame 240) and the first portion 248a after the first portion 248a is accommodated into the first region 240d-1. After the first adhesive member 248c is applied between the conductive portion 244 (or the frame 240) and the first portion 248a, as the ultraviolet ray is irradiated to the first adhesive member 248c, the support bracket 248 may be coupled to the conductive portion 244 (or the frame 240).

According to an embodiment, the second portion 248b may be connected to the first portion 248a. A size of the second portion 248b may be larger than the size of the first portion 248a. For example, a width of the second portion 248b may be wider than a width of the first portion 248a. The second portion 248b may be disposed in the second region 240d-2 of the opening 240d. The second portion 248b may be disposed between the first portion 248a and the antenna module 400.

According to an embodiment, the cover member 247 may be coupled to the support bracket 248 by a second adhesive member 247a. For example, the cover member 247 may be attached onto the support bracket 248 by the second adhesive member 247a. The second adhesive member 247a may be disposed between the cover member 247 and the support bracket 248.

As described above, according to an embodiment, the electronic device 200 may provide a structure in which the cover member 247 for covering the antenna module 400 may be stably coupled to the frame 240 as the opening 240d includes a structure having a step difference.

In case that an electronic component having a shape of a module is disposed in a frame (a housing or a support member), a fastening member (e.g., screw) for stable coupling between the module and the frame may be used. For example, the fastening member may contact at least a portion of the module and the frame in order to secure performance of the electronic component included in the module. For stable coupling between the module and the frame, since the fastening member has a size greater than or equal to a designated size, the size of a space in the frame in which electronic components may be disposed may be decrease due to the size of the fastening member. The electronic device may need a structure for securing a space in a frame while stably coupling the module and the frame.

An electronic device (e.g., the electronic device 200 of FIG. 2) is provided. According to an embodiment, the electronic device may comprise a conductive portion (e.g., the conductive portion 244 of FIGS. 4A, 4B, and 4C) including at least one through-hole (e.g., at least one through-hole 245 of FIG. 4B and FIG. 4C). According to an embodiment, the electronic device may comprise an antenna module (e.g., the antenna module 400 of FIGS. 4A, 4B, 4C, and 4D) disposed on the conductive portion. According to an embodiment, the antenna module may include a printed circuit board (e.g., the third printed circuit board 410 of FIG. 4D) including an antenna radiator (e.g., the antenna radiator 411 of FIG. 4D). According to an embodiment, the antenna module may include a conductive bracket (e.g., the conductive bracket 420 of FIGS. 4A, 4B, 4C, and 4D), surrounding at least a portion of the printed circuit board, electrically connected to a ground layer of the printed circuit board 410. According to an embodiment, the antenna module may include a conductive deformable member (e.g., the conductive deformation member 430 of FIG. 4C), accommodated in the conductive bracket, electrically connecting the conductive bracket to the conductive portion by contacting the conductive portion and the conductive bracket. According to an embodiment, the antenna module may include a conductive pin (e.g., at least one conductive pin 440 of FIGS. 4A, 4B, and 4C) that couples the antenna module to the conductive portion by penetrating the at least one through-hole, the conductive bracket, and the conductive deformation member.

According to an embodiment, the electronic device may provide a structure in which the antenna module may be stably coupled in the conductive portion by the conductive deformation member filling a space between the conductive bracket and the conductive portion.

According to an embodiment, the conductive pin may comprise a first extending portion (e.g., the first extending portion 443 of FIGS. 4A and 4B) penetrating the conductive bracket. According to an embodiment, the conductive pin may comprise a second extending portion (e.g., the second extending portion 444 of FIGS. 4A and 4B) being bent with respect to the first extending portion. For example, the second extending portion (e.g., the second extending portion 444 of FIGS. 4A and 4B) of the conductive pin may be formed at a right angle with respect to the first extending portion. According to an embodiment, the second extending portion may support the coupling of the antenna module and the conductive portion by contacting the conductive portion at an outside of the at least one through-hole.

According to an embodiment, the electronic device may provide a structure in which the coupling between the antenna module and the conductive portion is stable by the second extending portion contacting the conductive portion at the outside of the at least one through-hole.

According to an embodiment, the first extending portion may be inserted into the at least one through-hole. According to an embodiment, the conductive portion may include a receiving groove (e.g., at least one receiving groove 246 of FIGS. 4A and 4B) corresponding to the second extending portion. According to an embodiment, an end of the receiving groove may be opened toward an inside of the conductive portion.

According to an embodiment, the electronic device may provide a structure in which the conductive pin is easily separated from the conductive portion, since at least one receiving groove is opened.

According to an embodiment, the conductive pin may include a first body. According to an embodiment, the conductive pin may include a second body (e.g., the second body 446 of FIGS. 7A and 7B), surrounded by the first body (e.g., the first body 445 of FIGS. 7A and 7B), being movable with respect to the first body. According to an embodiment, the second body, by moving with respect to the first body, may be accommodated into an inside of the first body or protruded to an outside of the first body.

According to an embodiment, the electronic device may provide a structure in which the conductive bracket may be easily disposed in the conductive portion, since the conductive pin includes a first portion and a second portion movable with respect to each other.

According to an embodiment, the second body may include a first extending portion (e.g., the first extending portion 446a of FIGS. 7A and 7B). According to an embodiment, the second body may include a second extending portion (e.g., the second extending portion 446b of FIGS. 7A and 7B) being bent with respect to the first extending portion. For example, the second extending portion (e.g., the second extending portion 446b of FIGS. 7A and 7B) of the second body may be formed at a right angle with respect to the first extending portion. According to an embodiment, the conductive bracket may include a first receiving space (e.g., the first receiving space 423a of FIGS. 7A and 7B) extending parallel to the first extending portion. According to an embodiment, the conductive bracket may include a second receiving space (e.g., the second receiving space 423b of FIGS. 7A and 7B), connected to the first receiving space, being bent with respect to the first receiving space. For example, the second receiving space (e.g., the second receiving space 423b of FIGS. 7A and 7B) of the conductive bracket may be formed at a right angle with respect to the first receiving space. According to an embodiment, the second extending portion may be disposed in the first receiving space while the first extending portion protrudes to an outside of the first body. According to an embodiment, the second extending portion, while the first extending portion is accommodated in an inside of the first body, by a rotation of the conductive pin with respect to the conductive bracket, may move from the first receiving space to the second receiving space, or may move from the second receiving space to the first receiving space.

According to an embodiment, the electronic device may provide a structure in which the conductive bracket and the conductive portion are easily coupled, since the second extending portion is accommodated in one of the first receiving space and the second receiving space by movement of the conductive pin.

According to an embodiment, the at least one through-hole may include a first through-hole (e.g., the first through-hole 245a of FIG. 4B). According to an embodiment, the at least one through-hole may include a second through-hole (e.g., the second through-hole 245b of FIG. 4B) spaced apart from the first through-hole. According to an embodiment, the conductive pin may include a third body (e.g., the third body 447 of FIGS. 7A and 7B), inserted into the first through-hole, surrounded by the first body. According to an embodiment, the second body may be inserted into the second through-hole.

According to an embodiment, the electronic device may provide a structure in which the conductive bracket may be easily disposed in the conductive portion, since the conductive pin includes the first portion and the second portion movable with respect to each other.

According to an embodiment, the conductive pin may include an elastic member (e.g., the elastic member 448 of FIGS. 7A and 7B), disposed in the first body, configured to press the second body in a direction toward an outside of the first body.

According to an embodiment, the electronic device may provide a structure in which a position of the second body may be restored by the elastic member disposed in the first body.

According to an embodiment, the electronic device may comprise another printed circuit board (e.g., the first printed circuit board 250 of FIG. 3), disposed in the conductive portion, distinct from the printed circuit board. According to an embodiment, the antenna module may include a flexible printed circuit board (e.g., the flexible printed circuit board 412 of FIG. 4B) electrically connecting the printed circuit board and the another printed circuit board.

According to an embodiment, at least a portion of the conductive deformation member may be exposed to an outside of the conductive bracket by being disposed on an end of the conductive bracket.

According to an embodiment, the electronic device may provide a structure in which the conductive portion and the conductive bracket may be electrically connected, since the conductive deformation member is exposed to the outside of the conductive bracket.

According to an embodiment, the antenna module may include a conductive attachment member (e.g., the conductive attachment member 421 of FIG. 4D) electrically connecting the ground layer of the printed circuit board and the conductive bracket by being disposed between the conductive bracket and the printed circuit board.

According to an embodiment, the conductive pin may extend along a first direction. According to an embodiment, the conductive bracket may include a first cover surface (e.g., the first cover surface 420a of FIG. 4B) facing the first direction. According to an embodiment, the conductive bracket may include a second cover surface (e.g., the second cover surface 420b of FIG. 4B) opposite the first cover surface. According to an embodiment, the conductive deformation member and at least a portion of the printed circuit board may be covered by the first cover surface and the second cover surface by being disposed between the first cover surface and the second cover surface.

According to an embodiment, the conductive portion may include an opening (e.g., the opening 240d of FIG. 4B) penetrating the conductive portion. According to an embodiment, the electronic device may include a cover member (e.g., the cover member 247 of FIGS. 10A and 10B), filling at least a portion of the opening, being exposed to an outside of the conductive portion. According to an embodiment, the electronic device may include a support bracket (e.g., the support bracket 248 of FIGS. 10A and 10B) disposed between the cover member and the antenna module.

According to an embodiment, the support bracket may include a first portion (e.g., the first portion 248a of FIGS. 10A and 10B). According to an embodiment, the support bracket may include a second portion (e.g., the second portion 248b of FIGS. 10A and 10B), having a wider width than the first portion, disposed between the first portion and the antenna module. According to an embodiment, the electronic device may include a first adhesive member (e.g., the first adhesive member 248c of FIGS. 10A and 10B), disposed along a periphery of the first portion, being in contact with the first portion and the conductive portion.

According to an embodiment, the electronic device may comprise a second adhesive member (e.g., the second adhesive member 247a of FIGS. 10A and 10B) disposed between the cover member and the support bracket to attach the cover member to the support bracket.

According to an embodiment, the conductive portion may include a first coupling groove (e.g., the first coupling groove 910 of FIGS. 9A, 9B, and 9C) extending along a direction in which a first surface of the printed circuit board faces, the first surface of the printed circuit board on which the antenna radiator is disposed. According to an embodiment, the conductive portion may include a second coupling groove (e.g., the second coupling groove 920 of FIGS. 9A, 9B, and 9C), connected to the first coupling groove, being bent with respect to the first coupling groove. According to an embodiment, the conductive bracket may include at least one insertion hole (e.g., the insertion hole 422 of FIGS. 9A, 9B, and 9C) penetrated by the conductive pin. According to an embodiment, the conductive bracket may include a coupling protrusion (e.g., the coupling protrusion 424 of FIGS. 9A, 9B, and 9C) movable within the first coupling groove and the second coupling groove. According to an embodiment, when the coupling protrusion is inserted into the first coupling groove, when the conductive portion is viewed from above, the at least one insertion hole may be disposed outside the at least one through-hole. According to an embodiment, when the coupling protrusion is inserted into the second coupling groove, when the conductive portion is viewed from above, the at least one insertion hole may overlap the at least one through-hole.

According to an embodiment, the electronic device may provide a structure in which a coupling and/or separation between the conductive bracket and the conductive portion is easily performed by a coupling protrusion slidable in the first coupling groove and the second coupling groove.

An electronic device (e.g., the electronic device 200 of FIG. 2) is provided. According to an embodiment, the electronic device may comprise a surface (e.g., the side 240a of FIG. 4A) on which a display is disposed, another surface (e.g., the another side 240b of FIG. 4A) opposite to the surface, a conductive portion (e.g., the conductive portion 244 of FIGS. 4A, 4B, and 4C) including at least one through-hole (e.g., the at least one through-hole 245 of FIGS. 4B and 4C). According to an embodiment, the electronic device may comprise an antenna module (e.g., the antenna module 400 of FIGS. 4A, 4B, 4C, and 4D) disposed between the surface of the conductive portion and the another surface of the conductive portion. According to an embodiment, the antenna module may include a printed circuit board (e.g., the third printed circuit board 410 of FIG. 4D) including a first surface (e.g., the first surface 410a of FIG. 4D) on which an antenna radiator (e.g., the antenna radiator 411 of FIG. 4D) is disposed, a second surface (e.g., the second surface 410b of FIG. 4D) opposite to the first surface, and a ground layer. According to an embodiment, the antenna module may include a conductive bracket (e.g., the conductive bracket 420 of FIGS. 4A, 4B, 4C, and 4D), surrounding at least a portion of the printed circuit board, at least partially attached to the second surface, electrically connected to the ground layer. According to an embodiment, the antenna module may include a conductive deformation member (e.g., the conductive deformation member 430 of FIG. 4C), disposed on an end of the conductive bracket, electrically connecting the conductive bracket to the conductive portion by being interposed between the conductive portion and the conductive bracket. According to an embodiment, the antenna module may include a conductive pin (e.g., at least one conductive pin 440 of FIGS. 4A, 4B, and 4C) that couples the antenna module to the conductive portion by penetrating the at least one through-hole, the conductive bracket, and the conductive deformation member.

According to an embodiment, the electronic device may provide a structure in which the antenna module may be stably coupled to the conductive portion by the conductive deformation member filling the space between the conductive bracket and the conductive portion.

According to an embodiment, the conductive pin may comprise a first extending portion (e.g., the first extending portion 443 of FIGS. 4A and 4B) penetrating the conductive bracket. According to an embodiment, the conductive pin may comprise a second extending portion (e.g., the second extending portion 444 of FIGS. 4A and 4B) being bent with respect to the first extending portion. According to an embodiment, the second extending portion may support the coupling of the antenna module and the conductive portion by contacting the conductive portion at an outside of the at least one through-hole.

According to an embodiment, the electronic device may provide a structure in which the coupling between the antenna module and the conductive portion is stable by the second extending portion contacting the conductive portion at the outside of the at least one through-hole.

According to an embodiment, the conductive pin may include a first body. According to an embodiment, the conductive pin may include a second body (e.g., the second body 446 of FIGS. 7A and 7B) surrounded by the first body (e.g., the first body 445 of FIGS. 7A and 7B), being movable with respect to the first body. According to an embodiment, the second body may, by moving with respect to the first body, be accommodated into an inside of the first body or protruded to an outside of the first body.

According to an embodiment, the electronic device may provide a structure in which the conductive bracket may be easily disposed in the conductive portion, since the conductive pin includes the first portion and the second portion movable with respect to each other.

According to an embodiment, the antenna module may include a conductive attachment member (e.g., the conductive attachment member 421 of FIG. 4D) electrically connecting a ground layer of the printed circuit board and the conductive bracket by being disposed between the conductive bracket and the printed circuit board.

According to an embodiment, the conductive portion may include a first coupling groove (e.g., the first coupling groove 910 of FIGS. 9A, 9B, and 9C) extending along a direction in which a first surface of the printed circuit board faces, the first surface of the printed circuit board on which the antenna radiator is disposed. According to an embodiment, the conductive portion may include a second coupling groove (e.g., the second coupling groove 920 of FIGS. 9A, 9B, and 9C), connected to the first coupling groove, being bent with respect to the first coupling groove. According to an embodiment, the conductive bracket may include at least one insertion hole (e.g., the insertion hole 422 of FIGS. 9A, 9B, and 9C) penetrated by the conductive pin. According to an embodiment, the conductive bracket may include a coupling protrusion (e.g., the coupling protrusion 424 of FIGS. 9A, 9B, and 9C) movable within the first coupling groove and the second coupling groove. According to an embodiment, when the coupling protrusion is inserted into the first coupling groove, when the conductive portion is viewed from above, the at least one insertion hole may be disposed outside the at least one through-hole. According to an embodiment, when the coupling protrusion is inserted into the second coupling groove, when the conductive portion is viewed from above, the at least one insertion hole may overlap the at least one through-hole.

According to an embodiment, the electronic device may provide a structure in which the coupling and/or the separation between the conductive bracket and the conductive portion is easily performed by the coupling protrusion slidable in the first coupling groove and the second coupling groove.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200), comprising:
a conductive portion (244) including at least one through-hole (245); and
an antenna module (400) disposed on the conductive portion (244),
wherein the antenna module (400) includes:
a printed circuit board (410) including an antenna radiator (411);
a conductive bracket (420), surrounding at least a portion of the printed circuit board (410), electrically connected to a ground layer of the printed circuit board (410);
a conductive deformable member (430), accommodated in the conductive bracket (420), electrically connecting the conductive bracket (420) to the conductive portion (244) by contacting the conductive portion (244) and the conductive bracket (420); and
a conductive pin (440) that couples the antenna module (400) to the conductive portion (244) by penetrating the at least one through-hole (245), the conductive bracket (420), and the conductive deformation member (430).

2. The electronic device (101; 200) of claim 1,
wherein the conductive pin (440) comprises:
a first extending portion (443) penetrating the conductive bracket (420); and
a second extending portion (444) being bent with respect to the first extending portion (443),
wherein the second extending portion (444) supports the coupling of the antenna module (400) and the conductive portion (244) by contacting the conductive portion (244) at an outside of the at least one through-hole (245).

3. The electronic device (101; 200) of claim 2, wherein:
the first extending portion (443) is inserted into the at least one through-hole (245);
the conductive portion (244) includes a receiving groove (246) corresponding to the second extending portion (444); and
an end of the receiving groove (246) is opened toward an inside of the conductive portion (244).

4. The electronic device of any one of claims 1 to 3,
wherein the conductive pin (440) includes:
a first body (445); and
a second body (446), surrounded by the first body (445), being movable with respect to the first body (445), and
wherein the second body (446), by moving with respect to the first body (445), is accommodated into an inside of the first body (445) or protruded to an outside of the first body (445).

5. The electronic device (101; 200) of claim 4,
wherein the second body (446) includes:
a first extending portion (443); and
a second extending portion (444) being bent with respect to the first extending portion (443),
wherein the conductive bracket (420) further includes:
a first receiving space (423a) extending parallel to the first extending portion (443); and
a second receiving space (423b), connected to the first receiving space (423a), being bent with respect to the first receiving space (423a),
wherein the second extending portion (444) is disposed in the first receiving space (423a) while the first extending portion (443) protrudes to an outside of the first body (445), and
wherein the second extending portion (444), while the first extending portion (443) is accommodated in an inside of the first body (445), by a rotation of the conductive pin (440) with respect to the conductive bracket (420), moves from the first receiving space (423a) to the second receiving space (423b), or moves from the second receiving space (423b) to the first receiving space (423a).

6. The electronic device of any one of claim 4 and 5,
wherein the at least one through-hole (245) includes:
a first through-hole (245a); and
a second through-hole (245b) spaced apart from the first through-hole (245a),
wherein the conductive pin (440) further includes a third body (447), inserted into the first through-hole (245a), surrounded by the first body (445), and
wherein the second body (446) is inserted into the second through-hole (245b).

7. The electronic device (101; 200) of claim 6,
wherein the conductive pin (440) further includes an elastic member (448), disposed in the first body (445), configured to press the second body (446) in a direction toward an outside of the first body (445).

8. The electronic device (101; 200) of any one of claims 1 to 7, further comprising:
another printed circuit board (250), disposed in the conductive portion (244), distinct from the printed circuit board (410),
wherein the antenna module (400) further includes a flexible printed circuit board (412) electrically connecting the printed circuit board (410) and the another printed circuit board (250).

9. The electronic device (101; 200) of any one of claims 1 to 8,
wherein at least a portion of the conductive deformation member (430) is exposed to an outside of the conductive bracket (420) by being disposed on an end of the conductive bracket (420).

10. The electronic device of any one of claims 1 to 9,
wherein the antenna module (400) further includes a conductive attachment member (421) electrically connecting the ground layer of the printed circuit board (410) and the conductive bracket (420) by being disposed between the conductive bracket (420) and the printed circuit board (410).

11. The electronic device of any one of claims 1 to 10, wherein:
the conductive pin (440) extends along a first direction;
the conductive bracket (420) further includes:
a first cover surface (420a) facing the first direction, and
a second cover surface (420b) opposite the first cover surface (420a); and
wherein the conductive deformation member (430) and at least a portion of the printed circuit board (410) are covered by the first cover surface (420a) and the second cover surface (420b) by being disposed between the first cover surface (420a) and the second cover surface (420b).

12. The electronic device of any one of claims 1 to 11, wherein:
the conductive portion (244) further includes an opening (240d) penetrating the conductive portion (244); and
the electronic device (101; 200) further includes:
a cover member (247), filling at least a portion of the opening (240d), being exposed to an outside of the conductive portion (244), and
a support bracket (248) disposed between the cover member (247) and the antenna module (400).

13. The electronic device (101; 200) of claim 12, wherein:
the support bracket (248) includes:
a first portion (248a), and
a second portion (248b), having a wider width than the first portion (248a), disposed between the first portion (248a) and the antenna module (400); and
wherein the electronic device (101; 200) further includes a first adhesive member (248c), disposed along a periphery of the first portion (248a), being in contact with the first portion (248a) and the conductive portion (244).

14. The electronic device (101; 200) of any one of claim 12 and claim 13, further comprising a second adhesive member (247a) disposed between the cover member (247) and the support bracket (248) to attach the cover member (247) to the support bracket (248).

15. The electronic device of any one of claims 1 to 14, wherein:
the conductive portion (244) includes:
a first coupling groove (910) extending along a direction in which a first surface of the printed circuit board (410) faces, the first surface of the printed circuit board (410) on which the antenna radiator (411) is disposed, and
a second coupling groove (920), connected to the first coupling groove (910), being bent with respect to the first coupling groove (910);
the conductive bracket (420) includes:
at least one insertion hole (422) penetrated by the conductive pin (440), and
a coupling protrusion movable within the first coupling groove (910) and the second coupling groove (920); and
when the coupling protrusion is inserted into the first coupling groove (910), when the conductive portion (244) is viewed from above, the at least one insertion hole (422) is disposed outside the at least one through-hole (245); and
when the coupling protrusion is inserted into the second coupling groove (920), when the conductive portion (244) is viewed from above, the at least one insertion hole (422) overlaps the at least one through-hole (245).
